# EUROPEAN PATENT APPLICATION

(11) **EP 4 715 877 A1**
(43) Date of publication of application: **25.03.2026**
(21) Application number: 23939394.5
(22) Date of filing: 22.12.2023
(51) Int. Cl.: H01L 27/15, H01L 33/60, H01L 33/58, H01L 33/00

(54) **DISPLAY PANEL AND DISPLAY DEVICE**

(30) Priority: 29.05.2023 CN 202310625067
(71) Applicant: Boe Technology Group Co., Ltd., Beijing 100015 (CN); Hefei Boe Ruisheng Technology Co., Ltd., Hefei, Anhui 230012 (CN); Beijing BOE Technology Development Co., Ltd., Beijing 100176 (CN)
(72) Inventor: XU, Jiawei, Beijing 100176 (CN)
(74) Representative: Haseltine Lake Kempner LLP
(86) International application number: PCT/CN2023/140827
(87) International publication number: WO 2024/244426

(57) **Abstract**

Provided is a display panel. The display panel includes: a substrate; a first metal drive layer on a side of the substrate, wherein a plurality of conductive pads are arranged on the first metal drive layer; a light-absorbing layer on a side of the first metal drive layer, wherein an orthographic projection of the light-absorbing layer on the substrate is overlapped with an orthographic projection of the first metal drive layer on the substrate, and a plurality of first vias corresponding to the plurality of conductive pads are defined in the light-absorbing layer; a plurality of light-emitting units on a side of the light-absorbing layer, wherein the plurality of light-emitting units are electrically connected to at least part of the plurality of conductive pads through the plurality of first vias; and an auxiliary light-absorbing layer on a side of the plurality of light-emitting units.

## Description

This application claims priority to Chinese Patent Application No. 202310625067.3, filed on May 29, 2023 and entitled "DISPLAY PANEL AND DISPLAY DEVICE," the disclosure of which is herein incorporated by reference in its entirety.

### TECHNICAL FIELD

The present disclosure relates to the field of display technologies, and in particular, relates to a display panel and a display device.

### BACKGROUND

With development of the field of display technologies, a display panel equipped with light-emitting diodes (mini light-emitting diodes, LEDs for short) has advantages, such as pure chroma, wide dynamic range, high brightness, high definition, low operating voltage, low power consumption, long service life, impact resistance, large viewing angle, and stable and reliable operation, and the like. Therefore, the LED display panel becomes the most advantageous new-generation display media and has been widely used.

Currently, the LED display panel generally includes a drive backplane and a plurality of LEDs on a side of the drive backplane. The drive backplane transmits a drive signal to the plurality of LEDs, such that the plurality of LEDs emit corresponding light, and the LED display panel correspondingly displays images.

However, the drive backplane generally includes a metal layer, and reflectivity of the metal layer to ambient light is great. As such, the current LED display panel is prone to reflecting the ambient light, such that the LED display panel has a poor display effect.

### SUMMARY

Embodiments of the present disclosure provide a display panel and a display device, which can solve the problem of the poor effect of the LED display panel in some practices. The technical solutions are as follows.

In an aspect, a display panel is provided. The display panel includes: a substrate; a first metal drive layer on a side of the substrate, wherein a plurality of conductive pads are arranged on the first metal drive layer; a light-absorbing layer on a side, facing away from the substrate, of the first metal drive layer, wherein an orthographic projection of the light-absorbing layer on the substrate is overlapped with an orthographic projection of the first metal drive layer on the substrate, and a plurality of first vias corresponding to the plurality of conductive pads are defined in the light-absorbing layer, wherein an orthographic projection of each of the plurality of first vias on the substrate is overlapped with an orthographic projection of the corresponding conductive pad on the substrate; a plurality of light-emitting units on a side, facing away from the substrate, of the light-absorbing layer, wherein the plurality of light-emitting units are electrically connected to at least part of the plurality of conductive pads through the plurality of first vias; and an auxiliary light-absorbing layer on a side, facing away from the substrate, of the plurality of light-emitting units.

In some embodiments, the display panel further includes: a light-reflecting layer between the substrate and the light-absorbing layer, wherein an orthographic projection of the light-reflecting layer on the substrate is overlapped with the orthographic projection of the light-absorbing layer on the substrate.

In some embodiments, the light-reflecting layer is disposed on the side, facing away from the substrate, of the first metal drive layer, and second vias in communication with the plurality of first vias are defined in the light-reflecting layer.

In some embodiments, the orthographic projection of the light-absorbing layer on the substrate is within the orthographic projection of the light-reflecting layer on the substrate.

In some embodiments, the display panel further includes: a first insulative layer between the first metal drive layer and the light-absorbing layer, wherein third vias in communication with the plurality of first vias are defined in the first insulative layer.

In some embodiments, the light-reflecting layer is insulative, and the light-reflecting layer and the first insulative layer are in a same film layer structure .In some embodiments, the light-reflecting layer is disposed on a side, facing away from the substrate, of the first insulative layer, or the light-reflecting layer is disposed on a side, close to the substrate, of the first insulative layer.

In some embodiments, the display panel further includes: a second insulative layer on the side, facing away from the substrate, of the light-absorbing layer, wherein fourth vias in communication with the plurality of first vias are defined in the second insulative layer, and a portion of the second insulative layer extends into the plurality of first vias and covers at least part of inner walls of the plurality of first vias.

In some embodiments, the light-absorbing layer includes carbon particles, and the inner walls of the plurality of first vias are completely covered by the second insulative layer.

In some embodiments, the portion of the second insulative layer further extends into the second vias and covers at least part of inner walls of the second vias.

In some embodiments, the display panel further includes: a second metal drive layer on a side, close to the substrate, of the first metal drive layer, wherein the light-reflecting layer is disposed on a side, close to the substrate, of the second metal drive layer.

In some embodiments, mark patterns are arranged on at least one of the first metal drive layer or the second metal drive layer, and avoidance holes corresponding to the mark patterns are defined in the light-absorbing layer, wherein orthographic projections of the avoidance holes on the substrate are overlapped with orthographic projections of the mark patterns on the substrate.

In some embodiments, a material of the light-reflecting layer includes at least one of amorphous silicon, low-temperature polycrystalline silicon, or white ink.

In some embodiments, in a case that the material of the light-reflecting layer includes the amorphous silicon, a thickness of the light-reflecting layer ranges from 500 angstroms to 2000 angstroms; in a case that the material of the light-reflecting layer includes the white ink, a thickness of the light-reflecting layer ranges from 0.5 microns to 3 microns; or in a case that the material of the light-reflecting layer includes the low-temperature polycrystalline silicon, a thickness of the light-reflecting layer ranges from 500 angstroms to 2000 angstroms.

In some embodiments, the display panel further includes: a plurality of drive circuits on a side, close to the substrate, of the first metal drive layer, wherein the plurality of drive circuits are electrically connected to the plurality of light-emitting units through the plurality of conductive pads, and each of the plurality of drive circuits includes a plurality of laminated electrical patterns; and the display panel further includes: an insulative layer between adjacent two of the plurality of electrical patterns.

In some embodiments, the display panel further includes: a light-reflecting layer in a same layer as one of the plurality of electrical patterns, wherein an orthographic projection of the light-reflecting layer on the substrate is overlapped with the orthographic projection of the light-absorbing layer on the substrate.

In some embodiments, each of the plurality of drive circuits includes at least one transistor, wherein one of the plurality of electrical patterns is an active layer pattern in the at least one transistor, wherein a material of the active layer pattern and a material of the light-reflecting layer both include low-temperature polycrystalline silicon; and the active layer and the light-reflecting layer are disposed in a same layer with a same material.

In some embodiments, a width of a minimum spacing between an outer boundary of an orthographic projection of the active layer pattern on the substrate and an outer boundary of the orthographic projection of the light-reflecting layer on the substrate is greater than or equal to 5 microns.

In some embodiments, an edge region of a face, facing away from the first metal drive layer, of the substrate includes a bonding region, and the display panel further includes a plurality of signal lines in the bonding region, wherein at least part of the plurality of signal lines are electrically connected to the plurality of drive circuits, and a region between adjacent two of the plurality of drive signal lines is a spacer region, wherein an orthographic projection of the spacer region on the substrate is overlapped with the orthographic projection of the light-reflecting layer on the substrate.

In some embodiments, the spacer region includes a first region and a second region; wherein the first region is a region in the spacer region covered by the first metal drive layer and the plurality of electrical patterns, the second region is a region in the spacer region other than the first region, and at least part of the orthographic projection of the light-reflecting layer on the substrate is within an orthographic projection of the second region on the substrate.

In some embodiments, the orthographic projection of the light-reflecting layer on the substrate is not coincident with the orthographic projection of the first metal drive layer on the substrate, and is not coincident with orthographic projections of the plurality of electrical patterns on the substrate.

In some embodiments, the orthographic projection of the light-reflecting layer on the substrate completely covers the second region.

In some embodiments, a boundary of an orthographic projection of a portion of the light-reflecting layer covered by the second region on the substrate extends along a boundary of an orthographic projection of the first region on the substrate, and is not coincident with the boundary of the orthographic projection of the first region on the substrate.

In some embodiments, the display panel further includes: mark patterns in a same layer as at least one of the plurality of electrical patterns and made of a same material, and avoidance holes corresponding to the mark patterns are defined in the light-reflecting layer, wherein orthographic projections of the avoidance holes on the substrate are overlapped with orthographic projections of the mark patterns on the substrate.

In some embodiments, the plurality of electrical patterns include a first gate pattern, an active layer pattern, a second gate pattern, and a source-drain pattern that are laminated in a direction perpendicular to and away from the substrate, wherein in a case that the light-reflecting layer and the active layer pattern are disposed in a same layer, at least two mark patterns are defined, one of the at least two mark patterns being disposed in a same layer as the second gate pattern with a same material, and another other of the at least two mark patterns being disposed in a same layer as the source-drain pattern with a same material.

In some embodiments, a transmittance of the auxiliary light-absorbing layer to light emitted by the plurality of light-emitting units is greater than or equal to 50%.

In some embodiments, the plurality of light-emitting units include mini light-emitting diodes or micro light-emitting diodes.

In another aspect, a display device is provided. The display device includes: a drive assembly and a display panel electrically connected to the drive assembly, wherein the display panel is the above display panel.

The technical solutions according to the embodiments of the present disclosure at least have the following benefit effects.

A display panel includes: a substrate, a first metal drive layer, a light-absorbing layer, an auxiliary light-absorbing layer, and a plurality of light-emitting units. An orthographic projection of the light-absorbing layer on the substrate is overlapped with an orthographic projection of the drive layer on the substrate. As such, the light-absorbing layer absorbs ambient light irradiated to the display panel, such that reflection of the ambient light irradiated to the display panel by the drive layer is less, and reflectivity of the display panel to the ambient light is low. The reflectivity of the display panel to the ambient light is reduced by disposing the light-absorbing layer in the display panel. Thus, a transmittance of the auxiliary light-absorbing layer on a side, facing away from the substrate, of the plurality of light-emitting units is appropriately improved, such that absorptivity of the auxiliary light-absorbing layer to the light is low, and light emitted by the light-emitting units and absorbed by the auxiliary light-absorbing layer is less. As such, an overall display brightness of the display panel is higher even in the case that the display panel does not supply a large drive current to the light-emitting units, and thus power consumption of the display panel is effectively reduced.

### BRIEF DESCRIPTION OF DRAWINGS

For clearer description of the technical solutions according to the embodiments of the present disclosure, the following briefly introduces the accompanying drawings required for describing the embodiments. Apparently, the accompanying drawings in the following description show merely some embodiments of the present disclosure, and persons of ordinary skill in the art may still derive other drawings from these accompanying drawings without creative efforts.
FIG. 1 is a top view of a display panel according to some embodiments of the present disclosure;
FIG. 2 is a schematic diagram of a film layer structure of the display panel shown in FIG. 1 at a position A-A';
FIG. 3 is a schematic diagram of a film layer structure of a display panel according to some embodiments of the present disclosure;
FIG. 4 is a schematic diagram of a back face of a display panel according to some embodiments of the present disclosure;
FIG. 5 is a locally side view of a display panel according to some embodiments of the present disclosure;
FIG. 6 is a schematic diagram of a film layer structure of a drive backplane of a display panel according to some embodiments of the present disclosure;
FIG. 7 is a schematic diagram of a film layer structure of a drive backplane of a display panel according to some embodiments of the present disclosure;
FIG. 8 is a schematic diagram of a film layer structure of a drive backplane of a display panel according to some embodiments of the present disclosure;
FIG. 9 is a schematic diagram of a film layer structure of a drive backplane of a display panel according to some embodiments of the present disclosure;
FIG. 10 is a locally enlarged diagram of a drive backplane of a display panel according to some embodiments of the present disclosure;
FIG. 11 is a schematic diagram of a film layer structure of a drive backplane of a display panel according to some embodiments of the present disclosure;
FIG. 12 is a schematic diagram of a film layer structure of a drive backplane of a display panel according to some embodiments of the present disclosure;
FIG. 13 is a schematic diagram of a film layer structure of a drive backplane of a display panel according to some embodiments of the present disclosure;
FIG. 14 is a schematic diagram of a film layer structure of a drive backplane of a display panel according to some embodiments of the present disclosure;
FIG. 15 is a locally top view of a drive backplane of a display panel according to some embodiments of the present disclosure;
FIG. 16 is a locally top view of a display panel according to some embodiments of the present disclosure;
FIG. 17 is a schematic diagram of a film layer structure of a drive backplane of a display panel according to some embodiments of the present disclosure;
FIG. 18 is a schematic diagram of a film layer structure of a drive backplane of a display panel according to some embodiments of the present disclosure;
FIG. 19 is a locally enlarged diagram of a display panel from a back face according to some embodiments of the present disclosure;
FIG. 20 is a locally enlarged diagram of a display panel from a front face according to some embodiments of the present disclosure;
FIG. 21 is a locally schematic diagram of a single spacer region of a display panel from a front face according to some embodiments of the present disclosure;
FIG. 22 is a schematic diagram of a film layer structure of a drive backplane of a display panel according to some embodiments of the present disclosure;
FIG. 23 is a locally enlarged diagram of a display panel from a front face according to some embodiments of the present disclosure;
FIG. 24 is a locally enlarged diagram of a display panel from a front face according to some embodiments of the present disclosure;
FIG. 25 is a locally enlarged diagram of a display panel from a front face according to some embodiments of the present disclosure;
FIG. 26 is a locally enlarged diagram of a display panel from a front face according to some embodiments of the present disclosure; and
FIG. 27 is a locally enlarged diagram of a display panel from a front face according to some embodiments of the present disclosure.

### DETAILED DESCRIPTION

For clearer descriptions of the objects, technical solutions, and advantages of the embodiments of present disclosure, the embodiments of the present disclosure are described in detail hereinafter in combination with the accompanying drawings.

In some practices, black films are generally disposed in an LED display panel to reduce reflectivity of the LED display panel to ambient light. For example, in the LED display panel, the black films are disposed on a side, facing away from a drive backplane, of a plurality of LEDs, such that the black films absorb partial ambient light irradiated to the LED display panel, and reflection of the ambient light irradiated to the LED display panel by metal signal lines in the drive backplane is less.

However, absorptivity of the black films to the light needs to be great to reduce the reflectivity of the LED display panel to the ambient light. In the case that the absorptivity of the black films to the light is great, the transmittance of the black films is low. For example, the transmittance of the black films is usually less than 30%, such that the absorptivity of the black films to the light from the LED is great. As such, the driver backplane needs to provide a greater current to the LED to ensure that an overall display brightness of the LED is greater, and thus power consumption of the LED display panel is great.

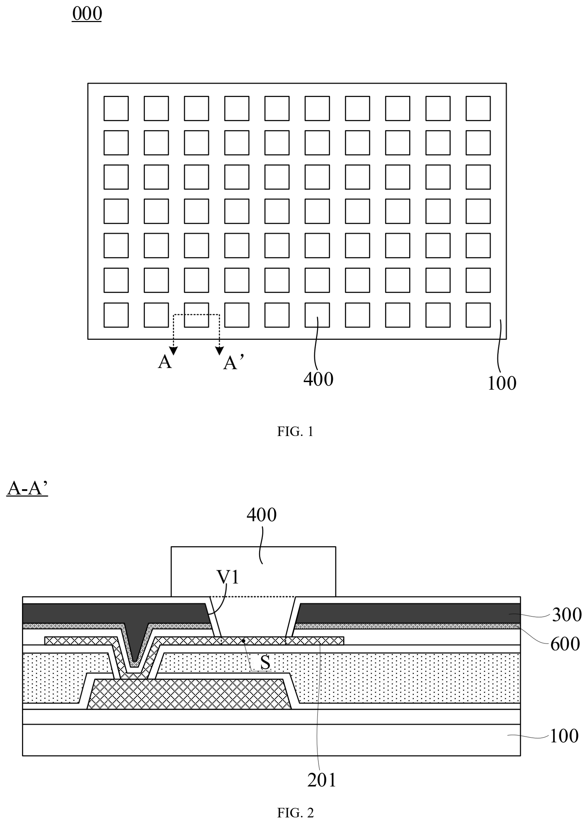

Referring to FIG. 1 and FIG. 2, FIG. 1 is a top view of a display panel according to some embodiments of the present disclosure, and FIG. 2 is a schematic diagram of a film layer structure of the display panel shown in FIG. 1 at a position A-A'. The display panel 000 includes: a substrate 100, a first metal drive layer 201, a light-absorbing layer 300, an auxiliary light-absorbing layer 500, and a plurality of light-emitting units 400.

The first metal drive layer 201 in the display panel 000 is disposed on a side of the substrate 100. A plurality of conductive pads S are arranged on the first metal drive layer 201. The first metal drive layer 201 is a metal layer with greater reflectivity.

The light-absorbing layer 300 in the display panel 000 is disposed on a side, facing away from the substrate 100, of the first metal drive layer 201. An orthographic projection of the light-absorbing layer 300 on the substrate 100 is overlapped with an orthographic projection of the first metal drive layer 201 on the substrate 100, such that the light-absorbing layer 300 absorbs ambient light irradiated to the display panel. Thus, reflection of the ambient light irradiated to the display panel by the first metal drive layer 201 is less, and reflectivity of the display panel 000 to the ambient light is low. In addition, a plurality of first vias V1 corresponding to the plurality of conductive pads S are defined in the light-absorbing layer 300 in the display panel 000, and an orthographic projection of each of the plurality of first vias V1 on the substrate 100 is overlapped with an orthographic projection of the corresponding conductive pad S on the substrate 100. For example, the orthographic projection of each of the plurality of first vias V1 on the substrate 100 is within the orthographic projection of the corresponding conductive pad S on the substrate 100. As such, the light-absorbing layer 300 does not block the conductive pad S, such that the conductive pad S is electrically connected to the light-emitting unit 400 subsequently.

Illustratively, in the display region of the display panel 000, the orthographic projection of the light-absorbing layer 300 in the display panel 000 on the substrate 100 covers an orthographic projection of a portion, other than the conductive pad S, in the first metal drive layer 201 on the substrate 100. That is, in the display region of the display panel 000, the portion, other than the conductive pad S, in the first metal drive layer 201 is blocked by the light-absorbing layer 300. It should be noted that the display region of the display panel indicates a region on a front face of the display panel 000 that can display images. Generally, the front face of the display panel 000 further includes a non-display region surrounding the display region. In some embodiments, the light-absorbing layer 300 in the display panel 000 is disposed in the non-display region of the display panel 000.

As the conductive pad in the first metal drive layer 201 needs to be connected to the light-emitting unit 400 and is blocked by the light-emitting unit 400, and the portion, other than the conductive pad S, in the first metal drive layer 201 is a metal portion with greater reflectivity and is not blocked by the light-emitting unit 400, the overall reflectivity of the display panel 000 is further reduced in the case that the light-absorbing layer 300 covers the portion, other than the conductive pad S, in the first metal drive layer 201.

The plurality of light-emitting units 400 in the display panel 000 are disposed on a side, facing away from the substrate 100, of the light-absorbing layer 300. The plurality of light-emitting units 400 are electrically connected to at least part of the plurality of conductive pads S through the plurality of first vias V1. In the present disclosure, the display panel 000 further includes a drive structure layer on a side, facing towards the substrate 100, of the first metal drive layer 201, and the drive structure layer is electrically connected to the first metal drive layer 201. As such, under joint action of the drive structure layer and the first metal drive layer 201, the light-emitting unit 400 is driven to emit light by the conductive pad S. It should be noted that a portion of the display panel 000 under the plurality of light-emitting units 400 is the drive backplane of the display panel 000. That is, the drive backplane includes the substrate 100, and the first metal drive layer 201 and the light-absorbing layer 300 on the side of the substrate 100. The plurality of light-emitting units 400 in the display panel 000 are all disposed on the drive backplane. A portion under the plurality of light-emitting units 400 indicates a side opposite to a light-emitting direction of the plurality of light-emitting units 400.

In the present disclosure, the light-emitting unit 400 in the display panel 000 includes the LED. In some embodiments, the drive backplane in the display panel 000 directly drives the LED to emit light. In this case, the LED is directly driven to emit light by the drive backplane in the display panel 000.

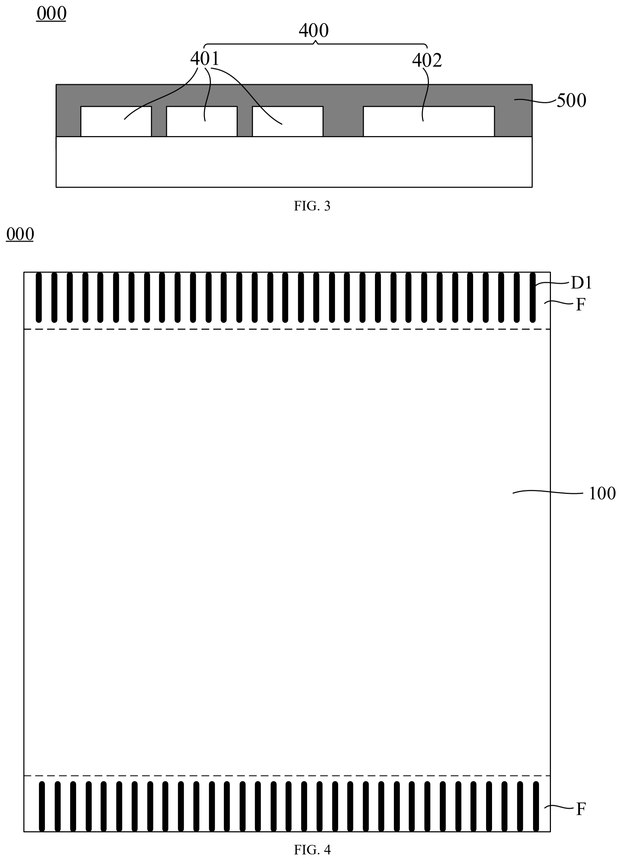

In some embodiments, as shown in FIG. 3, FIG. 3 is a schematic diagram of a film layer structure of a display panel according to some embodiments of the present disclosure. The light-emitting unit 400 in the display panel 000 includes the LED, and also includes a drive chip 402. The LED 401 and the drive chip 402 in the light-emitting unit 400 all need to be electrically connected to the first metal drive layer 201 in the display panel 000 by the conductive pad S. In this case, the LED 401 is driven to emit light by the drive backplane and the drive chip 402 in the display panel 000.

It should be noted that the LED in the light-emitting unit 400 is a regularly-sized LED, a mini LED, or a micro-LED.

In the embodiments of the present disclosure, colors of outer surfaces of LEDs in different light-emitting units 400 are greatly different from each other, and for the light-emitting unit 400 including the LED and the light-emitting chip, the color of an outer surface of the LED 401 of the light-emitting unit 400 is also greatly different from the color of an outer surface of the driver chip 402. Thus, the auxiliary light-absorbing layer 500 is disposed in the display panel 000. The auxiliary light-absorbing layer 500 is disposed on a side, facing away from the substrate 100, of the plurality of light-emitting units 400, and the auxiliary light-absorbing layer 500 simultaneously covers the LEDs 401 and the driver chips 402 in the light-emitting units 400. It should be noted that the auxiliary light-absorbing layer 500 is generally referred to as a black film. In the case that the auxiliary light-absorbing layer 500 simultaneously covers the LED 401 and the driver chip 402, the outer surface of the LED 401 and the outer surface of the driver chip 402 are black, such that the color difference between the outer surfaces of the LEDs in different light-emitting units 400 is effectively eliminated, and the color difference between the outer surface of the LED 401 and the driver chip 402 is effectively eliminated.

In the present disclosure, as the reflectivity of the display panel 000 to the ambient light is reduced by disposing the light-absorbing layer 300 in the display panel 000, the transmittance of the auxiliary light-absorbing layer 500 (that is, the black film) on the side, facing away from the substrate 100, of the plurality of light-emitting units 400 is appropriately improved. For example, the transmittance of the auxiliary light-absorbing layer 500 to the light from the light-emitting unit 400 is greater than or equal to 50%. In the case that no light-absorbing layer is arranged on the display panel, the transmittance of the black film in the display panel needs to be less than 30% to ensure that the reflectivity of the display panel to the ambient light is less. As such, in the case that the light-absorbing layer 300 is arranged on the display panel 000, the absorptivity of the auxiliary light-absorbing layer 500 to the light is low, and the light emitted by the light-emitting units 400 and absorbed by the auxiliary light-absorbing layer 500 is less. As such, the overall display brightness of the display panel 000 is higher even in the case that the display panel 000 does not supply a large drive current to the light-emitting units 400, and thus the power consumption of the display panel is effectively reduced. In some embodiments, the transmittance of the auxiliary light-absorbing layer 500 to the light from the light-emitting unit 400 is greater than or equal to 60%.

In the embodiments of the present disclosure, the transmittance of the auxiliary light-absorbing layer 500 in the display panel 000 is less than or equal to 90%, such that the color difference between the outer surfaces of the LEDs in different light-emitting units 400 is less, and for the light-emitting unit 400 including the LED and the light-emitting chip, the color difference between the outer surface of the LED and the outer surface of the driver chip in the light-emitting unit 400 is less.

In some embodiments, the light-absorbing layer 300 in the display panel includes a light-absorbing organic film layer made of an organic material. Illustratively, the organic material is a black matrix (BM) material. That is, the light-absorbing layer 300 is made of the BM material. As the BM material has great absorptivity, in the case that the absorption of the light-absorbing layer 300 to the ambient light irradiated to the display panel 000 is great, the reflectivity of the display panel 000 to the ambient light is efficiently reduced by the light-absorbing layer 300. For example, the BM material includes an organic material and a plurality of carbon particles dispersed in the organic material. The absorption of the BM material to the light is adjusted by adjusting concentration of the carbon particles in the organic material. It should be noted that the organic material includes an organic resin, polyimides (PI), polyvinyl alcohol (PVA), polyester (PET), poly(ethylene 2,6-naphthalenedi-carboxylate) (PEN), and other organic materials.

In some embodiments, a thickness of the light-absorbing layer 300 in the above embodiments ranges from 0.5 microns to 3 microns. The thicker the light-absorbing layer 300, the greater the absorptivity of the light-absorbing layer 300 to the light.

Illustratively, an optical density (OD) of the light-absorbing layer 300 is greater than or equal to 4. The OD of the light-absorbing layer 300 indicates the absorption of the light-absorbing layer 300 to the light. The greater the OD of the light-absorbing layer 300, the greater the absorptivity of the light-absorbing layer 300 to the light.

In the embodiments of the present disclosure, the auxiliary light-absorbing layer 500 in the display panel 000 includes a protection film, and a light-absorbing adhesive on a side, facing towards the substrate 100, of the protection film. The protection film in the auxiliary light-absorbing layer 500 is adhered to the side, facing away from the substrate 100, of the light-emitting unit 400 in the display panel 000 by the light-absorbing adhesive. As such, a protection layer in the auxiliary light-absorbing layer 500 protects the light-emitting unit 400 in the display panel 000 to avoid scratch of a surface of the light-emitting unit 400.

The light-absorbing adhesive in the auxiliary light-absorbing layer 500 includes a transparent adhesive having an adhering function, and a light-absorbing dye mixed in the transparent adhesive. For example, the light-absorbing dye is a black dye.

In summary, the display panel according to the embodiments of the present disclosure includes a substrate, a first metal drive layer, a light-absorbing layer, an auxiliary light-absorbing layer, and a plurality of light-emitting units. An orthographic projection of the light-absorbing layer on the substrate is overlapped with an orthographic projection of the drive layer on the substrate. As such, the light-absorbing layer absorbs ambient light irradiated to the display panel, such that reflection of the ambient light irradiated to the display panel by the driver layer is less, and reflectivity of the display panel to the ambient light is low. The reflectivity of the display panel to the ambient light is reduced by disposing the light-absorbing layer in the display panel. Thus, a transmittance of the auxiliary light-absorbing layer on a side, facing away from the substrate, of the plurality of light-emitting units is appropriately improved, such that absorptivity of the auxiliary light-absorbing layer to the light is low, and light emitted by the light-emitting units and absorbed by the auxiliary light-absorbing layer is less. As such, an overall display brightness of the display panel is higher even in the case that the display panel does not supply a large drive current to the light-emitting units, and thus power consumption of the display panel is effectively reduced.

In the embodiments of the present disclosure, the display panel 000 functions as a splicing display unit in a splicing display screen. As such, after a plurality of display panels 000 are spliced, a splicing display screen with a great size is acquired. In the case that the display panel 000 is used as the splicing display unit, a frame of the display panel 000 needs to be less. As such, in the present disclosure, the drive assembly is bonded to the display panel 000 in a back binding mode.

Illustratively, as shown in FIG. 4, FIG. 4 is a schematic diagram of a back face of a display panel according to some embodiments of the present disclosure. Edge drive of a face, facing away from the first metal drive layer 201, of the substrate 100 in the display panel 000 includes a bonding region F. The display panel 000 further includes a plurality of signal lines D1 in the bonding region F. At least part of the plurality of signal lines D1 are electrically connected to the first metal drive layer 201 in the display panel 000. The plurality of signal lines D1 in the bonding region F are configured to be bonded and connected to the drive assemblies, such that the drive assemblies are bonded to the display panel 000. As such, the drive assemblies transmit drive signals to the first metal drive layer 201 over the plurality of signal lines D1, such that the corresponding light-emitting units are lit. In the case that the drive assemblies are bonded to the back face of the display panel 000, the drive assemblies do not occupy space of the front face of the display panel 000, such that a screen-to-body ratio of the display panel 000 is great, and a width of the frame of the display panel 000 is less.

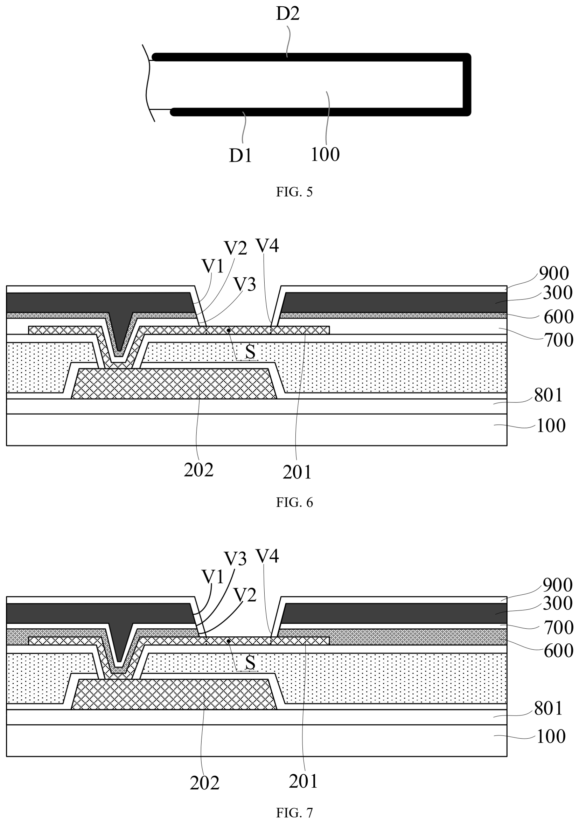

Illustratively, as shown in FIG. 5, FIG. 5 is a locally side view of a display panel according to some embodiments of the present disclosure. The display panel further includes a plurality of connection lines D2 electrically connected to the plurality of signal lines D1 correspondingly. One part of the plurality of connection lines D2 are disposed on a side, close to the first metal drive layer 201, of the substrate 100, and are electrically connected to a drive structure in the display panel 000. The other part of the plurality of connection lines D2 are disposed on a side face of the substrate 100, and end portions of back faces of the other part of the plurality of connection lines D2 are electrically connected to corresponding signal lines D1.

The plurality of connection lines D2 and the plurality of signal lines D1 are formed by one process. For example, the plurality of connection lines D2 and the plurality of signal lines D1 are formed by a laser etching process. Illustratively, upon preparation of the drive backplane, a conductive layer is sputtered in an edge region of the front face of the drive backplane, a side face of the drive backplane, and the bonding region of the back face of the drive backplane. The laser etching process is performed on the conductive layer to simultaneously form the plurality of connection lines D2 and the plurality of signal lines D1.

It should be noted that in the process of forming the plurality of signal lines D1 in the bonding region F by the laser etching process, the bonding region F needs to be irradiated with laser (for example, laser with a wavelength from 350 nm to 390 nm). In this process, the laser passes through the substrate 100 and is irradiated to a portion of the light-absorbing layer 300 in the bonding region F, and the light-absorbing layer 300 is made of an absorbent organic material, such that the light-absorbing layer 300 exhibits bubbling under the irradiation of laser, and a flatness of the light-absorbing layer 300 is poor.

Thus, as shown in FIG. 2, the display panel 000 in the embodiments of the present disclosure further includes a light-reflecting layer 600 between the substrate 100 and the light-absorbing layer 300. An orthographic projection of the light-reflecting layer 600 on the substrate 100 is overlapped with the orthographic projection of the light-absorbing layer 300 on the substrate 100.

Illustratively, the light-reflecting layer 600 reflects the laser passing through the substrate 100 and irradiated to the light-absorbing layer 300 to ensure that the laser is not irradiated to the light-absorbing layer 300, such that bubble of the light-absorbing layer 300 is efficiently avoided, the flatness of the light-absorbing layer 300 is great, and the reliability of the display panel 000 is great.

In some embodiments, a material of the light-reflecting layer 600 in the display panel 000 includes amorphous silicon, low-temperature polycrystalline silicon, or white ink. In some embodiments, in the case that the material of the light-reflecting layer 600 includes the amorphous silicon, the amorphous silicon is an inorganic insulative material and has great refractivity, such that the laser (for example, laser with a wavelength from 350 nm to 390 nm) irradiated to the amorphous silicon is prone to reflection. In addition, a thickness of the light-reflecting layer 600 ranges from 500 angstroms to 2000 angstroms, such that the laser irradiated to the light-reflecting layer 600 is reflected by the light-reflecting layer 600, and the laser is thus not irradiated to the light-absorbing layer 300.

In some embodiments, in the case that the material of the light-reflecting layer 600 includes the low-temperature polycrystalline silicon, the low-temperature polycrystalline silicon is a semiconductor material and has great refractivity, such that the laser (for example, laser with a wavelength from 350 nm to 390 nm) irradiated to the low-temperature polycrystalline silicon is prone to reflection. In addition, a thickness of the light-reflecting layer 600 ranges from 500 angstroms to 2000 angstroms, such that the laser irradiated to the light-reflecting layer 600 is reflected by the light-reflecting layer 600, and the laser is thus not irradiated to the light-absorbing layer 300.

In some embodiments, in the case that the material of the light-reflecting layer 600 includes the white ink, the white ink is an organic insulative material with scattering, a thickness of the light-reflecting layer 600 ranges from 0.5 microns to 3 microns, such that the laser irradiated to the light-reflecting layer 600 is reflected by the light-reflecting layer 600, the reflected laser is emitted in a scattering form, and the laser is thus not irradiated to the light-absorbing layer 300.

In the embodiments of the present disclosure, structures of the drive structure layer on a side, facing towards the substrate, of the first metal drive layer 201 in the display panel are diverse. For example, the drive structure layer is a second metal drive layer 202. For example, the drive structure layer includes a plurality of drive circuits. In addition, locations of the light-reflecting layer 600 between the substrate 100 and the light-absorbing layer 300 in the display panel 000 are diverse. As such, embodiments of the present disclosure are illustrated by taking following four optional implementations as an example.

In a first optional implementation, referring to FIG. 6, FIG. 6 is a schematic diagram of a film layer structure of a drive backplane of a display panel according to some embodiments of the present disclosure. The drive backplane of the display panel 000 indicates a portion of the display panel 000 not including the light-emitting unit 400. The light-reflecting layer 600 in the display panel 000 is disposed on a side, facing away from the substrate 100, of the first metal drive layer 201, and the display panel 000 further includes a second metal drive layer 202 on a side, close to the substrate 100, of the first metal drive layer 201. That is, the light-reflecting layer 600 is disposed between the first metal drive layer 201 and the light-absorbing layer 300, and the drive structure layer in the display panel 000 is the second metal drive layer 202. In this case, second vias V2 in communication with the plurality of first vias V1 are defined in the light-reflecting layer 600. As such, the light-emitting unit 400 in the display panel 000 is electrically connected to the conductive pad S through the first via V1 and the second via V2.

In the present disclosure, in the case that the light-reflecting layer 600 is disposed between the first metal drive layer 201 and the light-absorbing layer 300, the second vias V2 in the light-reflecting layer 600 and the first vias V1 in the light-absorbing layer 300 are formed by a single patterning process. The single patterning process includes photoresist coating, exposing, developing, etching, and photoresist removing. In this case, the light-reflecting layer 600 and the light-absorbing layer 300 are sequentially formed in a whole layer, then the first vias V1 are formed in the light-absorbing layer 300 by a single patterning process, and the second vias V2 in communication with the first vias V1 are formed in the light-reflecting layer 600, such that the process difficulty of the display panel 000 is reduced.

In some embodiments, the orthographic projection of the light-absorbing layer 300 on the substrate 100 is within the orthographic projection of the light-reflecting layer 600 on the substrate 100. As such, in the process of forming a plurality of signal lines D1 in the bonding region F by the laser etching process, the laser irradiated to the bonding region F passes through the substrate 100 and the first metal drive layer 201, and then is reflected by the light-reflecting layer 600, such that the laser is not irradiated to the light-absorbing layer 300.

In the embodiments of the present disclosure, the display panel 000 further includes a first insulative layer 700 between the first metal drive layer 201 and the light-absorbing layer 300. Third vias V3 in communication with the plurality of first vias V1 are defined in the first insulative layer 700, such that the light-emitting unit 400 in the display panel 000 is electrically connected to the conductive pad S through the first via V1 and the third via V3.

It should be noted that as the light-absorbing layer 300 in the display panel 000 is insulative, the light-absorbing layer 300 is directly in contact with the side, facing away from the substrate 100, of the first metal drive layer 201, and the first insulative layer 700 is directly in contact with the side, facing away from the substrate 100, of the light-absorbing layer 300. Thus, the embodiments of the present disclosure are illustrated by taking following three cases as an example.

In a first case, as shown in FIG. 6, the first insulative layer 700 in the display panel 000 is directly in contact with the side, facing away from the substrate 100, of the drive layer 300. The light-reflecting layer 600 in the display panel 000 is disposed on the side, facing away from the substrate 100, of the first insulative layer 700. In this case, the first vias V1 in the light-absorbing layer 300, the second vias V2 in the light-reflecting layer 600, and the third vias V3 in the first insulative layer 700 are sequentially communicated, and the light-emitting unit 400 is electrically connected to the conductive pad S through the first via V1, the second via V2, and the third via V3. In addition, the first vias V1 in the light-absorbing layer 300, the second vias V2 in the light-reflecting layer 600, and the third vias V3 in the first insulative layer 700 are simultaneously formed by a single patterning process.

It should be noted that in this case, the material of the light-reflecting layer 600 in the display panel 000 is the amorphous silicon or the white ink. In addition, the first insulative layer 700 is made of an inorganic material with a great moisture-oxygen seal capability. As such, in the case that the first insulative layer 700 is directly in contact with the side, facing away from the substrate 100, of the first metal drive layer 201, the first insulative layer 700 ensures that moisture and oxygen in the external environment do not erode the first metal drive layer 201 from the side, facing away from the substrate 100, of the first metal drive layer 201, and thus a possibility of oxidizing and eroding the first metal drive layer 201 is efficiently reduced. In addition, in the case that the material of the light-reflecting layer 600 in the display panel 000 is the amorphous silicon, as the amorphous silicon is an inorganic insulative material, the first metal drive layer 201 is further protected by laminating the first insulative layer 700 and the light-reflecting layer 600.

In a second case, as shown in FIG. 7, FIG. 7 is a schematic diagram of a film layer structure of a drive backplane of a display panel according to some embodiments of the present disclosure. The light-reflecting layer 600 in the display panel 000 is directly in contact with the side, facing away from the substrate 100, of the drive layer 300. The first insulative layer 700 in the display panel 000 is disposed on the side, facing away from the substrate 100, of the light-reflecting layer 600. In this case, the first vias V1 in the light-absorbing layer 300, the third vias V3 in the first insulative layer 700, and the second vias V2 in the light-reflecting layer 600 are sequentially communicated, and the light-emitting unit 400 is electrically connected to the conductive pad S through the first via V1, the third via V3, and the second via V2. In addition, the first vias V1 in the light-absorbing layer 300, the third vias V3 in the first insulative layer 700, and the second vias V2 in the light-reflecting layer 600 are simultaneously formed by a single patterning process.

It should be noted that in this case, the material of the light-reflecting layer 600 in the display panel 000 is the amorphous silicon. As the amorphous silicon is an inorganic insulative material, the light-reflecting layer 600 ensures that moisture and oxygen in the external environment do not erode the first metal drive layer 201 from the side, facing away from the substrate 100, of the first metal drive layer 201, and thus the possibility of oxidizing and eroding the first metal drive layer 201 is efficiently reduced. In addition, the first insulative layer 700 is made of an inorganic material with the great moisture-oxygen seal capability, or is made of an organic material with the great flatness, which is not limited in the embodiments of the present disclosure.

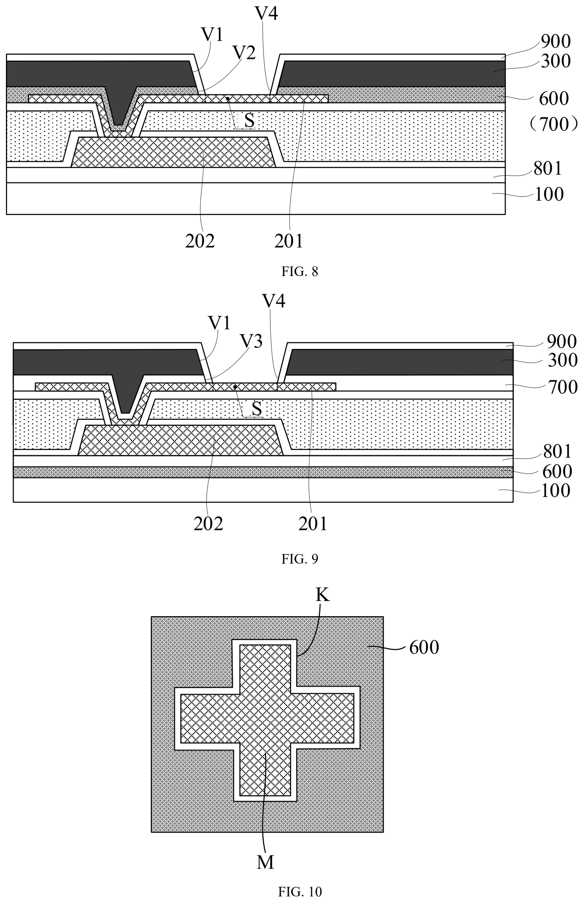

In a third case, as shown in FIG. 8, FIG. 8 is a schematic diagram of a film layer structure of a drive backplane of a display panel according to some embodiments of the present disclosure. The light-reflecting layer 600 in the display panel 000 is directly in contact with the side, facing away from the substrate 100, of the drive layer 300, and the light-reflecting layer 600 and the first insulative layer 700 in the display panel 000 are in a same film layer structure. In this case, the light-reflecting layer 600 in the display panel 000 reflects the laser, and insulates the first metal drive layer 201 from the light-absorbing layer 300. In addition, a number of layers in the film layer structure in the display panel is reduced, such that manufacturing cost of the display panel 000 is reduced.

It should be noted that in this case, the material of the light-reflecting layer 600 in the display panel 000 is the amorphous silicon. As such, the light-reflecting layer 600 ensures that moisture and oxygen in the external environment do not erode the first metal drive layer 201 from the side, facing away from the substrate 100, of the first metal drive layer 201, and thus the possibility of oxidizing and eroding the first metal drive layer 201 is efficiently reduced.

In a second optional implementation, referring to FIG. 9, FIG. 9 is a schematic diagram of a film layer structure of a drive backplane of a display panel according to some embodiments of the present disclosure. The light-reflecting layer 600 in the display panel 000 is disposed on a side, close to the substrate 100, of the first metal drive layer 201, and the display panel 000 further includes a second metal drive layer 202 on a side, close to the substrate 100, of the first metal drive layer 201. That is, the light-reflecting layer 600 is disposed between the first metal drive layer 201 and the substrate 100, and the drive structure layer in the display panel 000 is the second metal drive layer 202. Illustratively, the light-reflecting layer 600 is disposed between the second metal drive layer 202 and the substrate 100. As such, in the process of forming a plurality of signal lines D1 in the bonding region F by the laser etching process, the laser irradiated to the bonding region F passes through the substrate 100, and then is completely reflected by the light-reflecting layer 600, such that the laser is not irradiated to the light-absorbing layer 300. In the case that the light-reflecting layer 600 is disposed between the second metal drive layer 202 and the substrate 100, the laser irradiated to the bonding region F is reflected by the light-reflecting layer 600 upon passing through the substrate 100, without passing through the first metal drive layer 201, such that the reflection efficiency of the light-reflecting layer 600 to the laser is great.

In the embodiments of the present disclosure, referring to FIG. 10, FIG. 10 is a locally enlarged diagram of a drive backplane of a display panel according to some embodiments of the present disclosure. Mark patterns M are arranged on at least one of the first metal drive layer 201 and the second metal drive layer 202 in the display panel 000. After the mark patterns M are arranged on at least one of the first metal drive layer 201 and the second metal drive layer 202, a plurality of signal lines are disposed in the bonding region on the back face of the substrate 100. Alternatively, in the process of disposing the drive assemblies in the bonding region on the back face of the substrate 100, a location of at least one of the first metal drive layer 201 and the second metal drive layer 202 in the substrate is determined based on the mark patterns M, such that the signal lines formed in the bonding region are accurately and electrically connected to the first metal drive layer 201 and the second metal drive layer 202, and the drive assemblies are accurately bonded in the bonding region.

In the case that the light-reflecting layer 600 in the display panel 000 is disposed between the substrate 100 and the second metal drive layer 202, the light-reflecting layer 200 blocks the mark pattern M in at least one of the first metal drive layer 201 and the second metal drive layer 202, such that the mark pattern M is not identified from the back face of the substrate 100 subsequently. Thus, avoidance holes K are required in the light-reflecting layer 600. An orthographic projection of the avoidance hole K in the light-reflecting layer 600 on the substrate 100 is overlapped with an orthographic projection of the mark pattern M in the first metal drive layer 201 on the substrate 100. Illustratively, the orthographic projection of the mark pattern M on the substrate 100 is within the orthographic projection of the avoidance hole K on the substrate 100. As such, the mark pattern M in at least one of the first metal drive layer 201 and the second metal drive layer 202 is exposed from the avoidance hole K in the light-reflecting layer 600, such that the mark pattern M is identified from the back face of the substrate 100. In addition, shapes of the orthographic projection of the mark pattern M on the substrate 100 and the orthographic projection of the avoidance hole K on the substrate 100 are the same, and a spacing between a boundary of the orthographic projection of the mark pattern M on the substrate 100 and a boundary of the orthographic projection of the avoidance hole K on the substrate 100 is less, for example, less than or equal to 1 micron. As such, in the process of forming a plurality of signal lines D1 in the bonding region F by the laser etching process, laser passing through the avoidance hole K is blocked by the mark pattern M even though the laser passes through the avoidance hole K in the light-reflecting layer 600.

It should be noted that for the first optional implementation, that is, in the case that the light-reflecting layer 600 in the display panel 000 is disposed between the first metal drive layer 201 and the light-absorbing layer 300, the first metal drive layer 201 is closer to the substrate 100 than the light-reflecting layer 600. Thus, the light-reflecting layer 600 does not block the first metal drive layer 201 from the side of the back face of the substrate 100. As such, even though the avoidance hole is not disposed in the light-reflecting layer 600, the mark pattern M in at least one of the first metal drive layer 201 and the second metal drive layer 202 is identified from the back face of the substrate 100. In this case, it is unnecessary to form the light-reflecting layer 600 in the display panel 000 by the single patterning process, the light-reflecting layer 600 and the light-absorbing layer 200 are simultaneously formed by the single patterning process, such that the manufacturing difficulty of the display panel 000 is further reduced.

In some embodiments, for the first optional implementation and the second optional implementation, the display panel 000 drives the light-emitting units 300 in the display panel 000 to emit light under the action of the first metal drive layer 201 and the second metal drive layer 202, and the light-emitting units 400 in the display panel 000 in the architecture needs to be provided with the LED 401 and the drive chip 402. The following embodiments illustrate other structures in the display panel 000 in the architecture and drive principles of the display panel 000.

As shown in FIG. 6 to FIG. 9, the display panel 000 further includes a first inorganic protection layer 801 between the second metal drive layer 202 and the substrate 100. The first inorganic protection layer 801 ensures that moisture and oxygen in the external environment do not erode the first metal drive layer 201 from the side, close to the substrate 100, of the first metal drive layer 201, and thus the possibility of oxidizing and eroding the first metal drive layer 201 is further reduced.

It should be noted that for the first optional implementation, that is, in the case that the light-reflecting layer 600 in the display panel 000 is disposed between the first metal drive layer 201 and the light-absorbing layer 300, the first inorganic protection layer 801 in the display panel 000 is directly in contact with the side, close to the substrate 100, of the first metal drive layer 201.

For the second optional implementation, that is, in the case that the light-reflecting layer 600 in the display panel 000 is disposed between the second metal drive layer 202 and the substrate 100, and the material of the light-reflecting layer 600 is the amorphous silicon, the first inorganic protection layer 801 is disposed on a side, close to the substrate 100, of the light-reflecting layer 600, or disposed on a side, facing away from the substrate 100, of the light-reflecting layer 600, or the first inorganic protection layer 801 and the light-reflecting layer 600 are in a same film layer structure, which is not limited in the embodiments of the present disclosure. In the case that the material of the light-reflecting layer 600 is the white ink, the first inorganic protection layer 801 needs to be disposed on the side, facing away from the substrate 100, of the light-reflecting layer 600, such that the first inorganic protection layer 801 is directly in contact with the side, close to the substrate 100, of the second metal drive layer 202, and thus the first inorganic protection layer 801 protects the first metal drive layer 201 better.

In some embodiments, as shown in FIG. 6 to FIG. 9, the display panel 000 further includes a second insulative layer 900 on the side, facing away from the substrate 100, of the light-absorbing layer 300. As such, the second insulative layer 900 protects the light-absorbing layer 300 in the display panel 000 to ensure that a blocking effect of the light-absorbing layer 300 to the first metal drive layer 201 and the second metal drive layer 202 is not poor due to scratch of the light-absorbing layer 300.

In the present disclosure, fourth vias V4 in communication with the plurality of first vias V1 are defined in the second insulative layer 900. In this case, the plurality of light-emitting units 400 in the display panel 000 are disposed on the side, facing away from the substrate 100, of the second insulative layer 900, and the light-emitting unit 400 is electrically connected to the conductive pad S through the fourth via V4 and the first via V1.

In some embodiments, as shown in FIG. 6 to FIG. 9, a portion of the second insulative layer 900 extends into the plurality of first vias V1 and covers at least part of inner walls of the plurality of first vias V1. In this case, the fourth vias V4 in communication with the first vias V1 are defined in the portion of the second insulative layer 900 extending into the first vias V1, and orthographic projections of the fourth vias V4 on the substrate 100 are within orthographic projections of the first vias V1 on the substrate 100. As such, the portion of the second insulative layer 900 extending into the first vias V1 protects at least part of inner walls of the first vias V1.

Illustratively, the inner wall of the first via V1 in the light-absorbing layer 300 is completely covered by the second insulative layer 900. That is, the portion of the second insulative layer 900 extending into the first vias V1 completely covers the inner wall of the first vias V1. In this case, the second insulative layer 900 covers the light-absorbing layer 300 at all locations to ensure the light-absorbing layer 300 is not exposed.

In some embodiments, the light-absorbing layer 300 in the display panel generally includes carbon particles. The light-absorbing layer 300 has a light-absorbing capability due to the carbon particles. As in the process of manufacturing the display panel 00, the display panel 000 needs to be immersed in a gold bath tank, the solution (generally the acidic or alkaline solution) in the gold bath tank precipitates the carbon particles in the light-absorbing layer 300, such that the gold bath tank is contaminated. Thus, in order to prevent the gold bath tank from being contaminated, the portion of the second insulative layer 900 extending into the first vias V1 needs to completely cover the inner wall of the first vias V1 to ensure that the light-absorbing layer 300 is not exposed, and then ensure that the solution in the gold bath tank does not precipitate the carbon particles in the light-absorbing layer 300 in the case that the display panel 000 is immersed in the gold bath tank, such that the gold bath tank is not contaminated.

It should be noted that for the first optional implementation, that is, in the case that the light-reflecting layer 600 in the display panel 000 is disposed between the first metal drive layer 201 and the light-absorbing layer 300, the portion of the second insulative layer 900 extending into the first vias V1 further extends into the second vias V2, and covers at least part of inner walls of the second vias V2, as shown in FIG. 6 to FIG. 8. Similarly, the portion of the second insulative layer 900 extending into the first vias V1 further extends into the third vias V3, and covers at least part of inner walls of the third vias V3. Illustratively, the inner walls of the second vias V2 are completely covered by the second insulative layer 900, and the inner walls of the third vias V3 are completely covered by the second insulative layer 900.

In the embodiments of the present disclosure, a type pf the second insulative layer 900 in the display panel 000 is diverse. For example, the second insulative layer 900 includes at least one of an inorganic insulative layer or an organic insulative layer. In the case that the second insulative layer 900 in the display panel 000 includes the inorganic insulative layer 901 and the organic insulative layer 902, the fourth via V4 in the second insulative layer 900 includes first sub-vias V41 and second sub-vias V42. The first sub-vias V4 are defined in the inorganic insulative layer 901, and the second sub-vias V42 are defined in the organic insulative layer 902. The embodiments of the present disclosure are illustratively described by taking following four possible cases as an example.

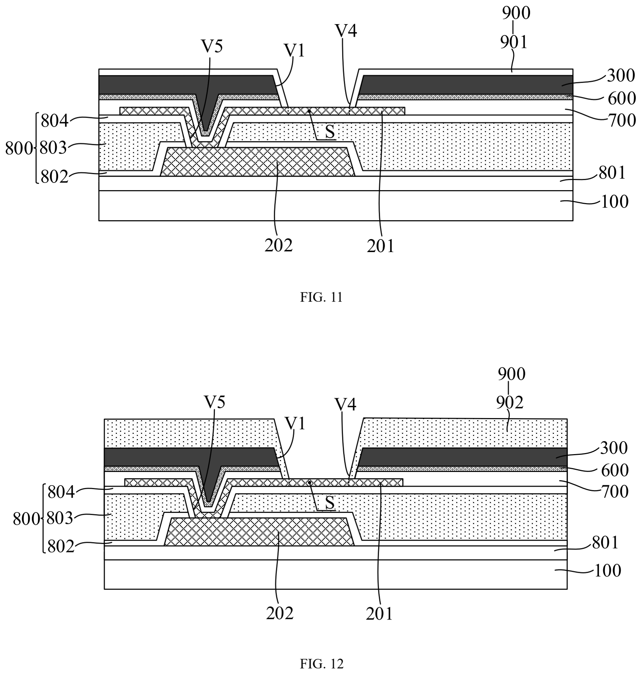

In a first possible case, as shown in FIG. 11, FIG. 11 is a schematic diagram of a film layer structure of a drive backplane of a display panel according to some embodiments of the present disclosure. In the case that the second insulative layer 900 in the display panel 000 is a single film layer structure, and is the inorganic insulative layer 901, a portion of the inorganic insulative layer 901 extends into the first vias V1, and a portion of the inorganic insulative layer 901 extending into the first vias V1 completely covers the inner walls of the first vias V1 to ensure that the light-absorbing layer 300 is not exposed.

It should be noted that a portion of the inorganic insulative layer 901 outside the first vias V1 is in contact with the side, facing away from the substrate 100, of the light-absorbing layer 300. As such, the portion of the inorganic insulative layer 901 outside the first vias V1 protects the light-absorbing layer 300 from the side, facing away from the substrate 100, of the light-absorbing layer 300, and the portion of the inorganic insulative layer 901 in the first vias V1 protects the light-absorbing layer 300 from the inner walls of the first vias V1. As the inorganic insulative layer 901 has a great moisture-oxygen barrier capability, the protection effect of the light-absorbing layer 300 is effectively improved in the case that the inorganic insulative layer 901 wraps and protects the light-absorbing layer 300.

In a second possible case, as shown in FIG. 12, FIG. 12 is a schematic diagram of a film layer structure of a drive backplane of a display panel according to some embodiments of the present disclosure. In the case that the second insulative layer 900 in the display panel 000 is a single film layer structure, and is the organic insulative layer 902, a portion of the organic insulative layer 902 extending into the first vias V1 completely covers the inner walls of the first vias V1 to ensure that the light-absorbing layer 300 is not exposed.

It should be noted that a portion of the organic insulative layer 902 outside the first vias V1 is in contact with the side, facing away from the substrate 100, of the light-absorbing layer 300. As such, the portion of the organic insulative layer 902 outside the first vias V1 protects the light-absorbing layer 300 from the side, facing away from the substrate 100, of the light-absorbing layer 300, and the portion of the organic insulative layer 902 in the first vias V1 protects the light-absorbing layer 300 from the inner walls of the first vias V1. As the organic insulative layer 902 is greatly attached to the light-absorbing layer 300, the portion of the organic insulative layer 902 extending into the first vias V1 is closely attached to the inner walls of the first vias V1.

In addition, as the organic insulative layer 902 has the great flatness, the flatness of the side, facing away from the substrate 100, of the organic insulative layer 902 is great in the case that the organic insulative layer 902 is disposed on the side, facing away from the substrate 100, of the light-absorbing layer 300. In addition, in this case, the side, facing away from the substrate 100, of the organic insulative layer 902 is the outmost side of the drive backplane. Thus, in forming a plurality of light-emitting units 400 in the drive backplane, a face, facing away from the substrate 100, of the plurality of light-emitting units 400 is flat, such that the display effect of the display panel 000 is great.

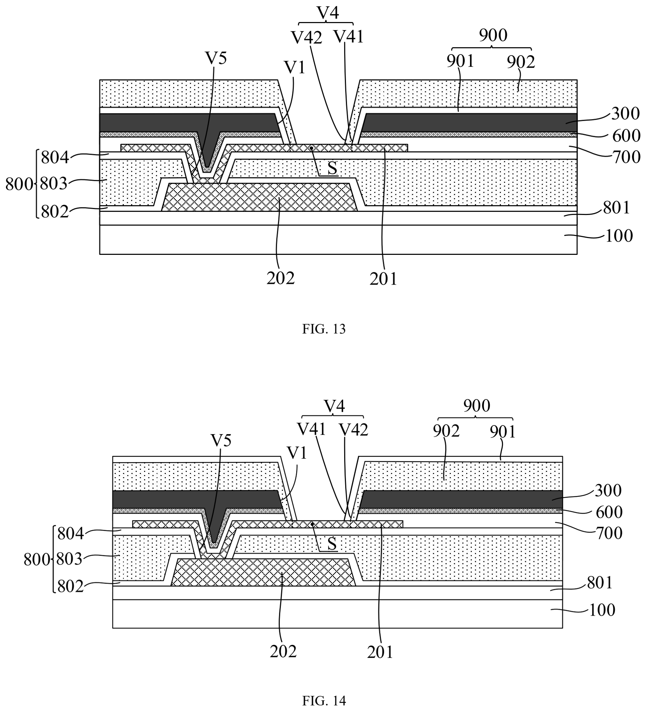

In a third possible case, as shown in FIG. 13, FIG. 13 is a schematic diagram of a film layer structure of a drive backplane of a display panel according to some embodiments of the present disclosure. In the case that the second insulative layer 900 in the display panel 000 is a double film layer structure, that is, includes the inorganic insulative layer 901 and the organic insulative layer 902, and the inorganic insulative layer 901 is closer to the light-absorbing layer 300 than the organic insulative layer 902, a portion of the inorganic insulative layer 602 extends into the first vias V1 and covers the inner walls of the first vias V1, and/or, a portion of the organic insulative layer 902 extends into the first vias V1 and covers the inner walls of the first vias V1.

Illustratively, in FIG. 13, the inorganic insulative layer 901 and the organic insulative layer 902 both include a portion extending into the first vias V, the portion of the inorganic insulative layer 901 extending into the first vias V1 completely covers the inner walls of the first vias V1, and the portion of the organic insulative layer 603 extending into the first vias V1 completely covers a portion of the inorganic insulative layer 901 facing away from the inner walls of the first vias V1, such that the light-absorbing layer 300 is not exposed.

It should be noted that a portion of the inorganic insulative layer 901 outside the first vias V1 is in contact with the side, facing away from the substrate 100, of the light-absorbing layer 300, and a portion of the organic insulative layer 902 outside the first vias V1 is in contact with the side, facing away from the substrate 100, of the inorganic insulative layer 901. As such, the portion of the inorganic insulative layer 901 outside the first vias V1 and the portion of the organic insulative layer 902 outside the first vias V1 protect the light-absorbing layer 300 from the side, facing away from the substrate 100, of the light-absorbing layer 300, and the portion of the inorganic insulative layer 901 in the first vias V1 and the portion of the organic insulative layer 902 in the first vias V1 protect the light-absorbing layer 300 from the inner walls of the first vias V1.

In addition, as the organic insulative layer 902 has the great flatness, the flatness of the side, facing away from the substrate 100, of the organic insulative layer 902 is great in the case that the organic insulative layer 902 is disposed on the side, facing away from the substrate 100, of the inorganic insulative layer 901. In addition, in this case, the side, facing away from the substrate 100, of the organic insulative layer 902 is the outmost side of the drive backplane. Thus, in forming a plurality of light-emitting units 400 in the drive backplane, a face, facing away from the substrate 100, of the plurality of light-emitting units 400 is flat, such that the display effect of the display panel 000 is great.

In a fourth possible case, as shown in FIG. 14, FIG. 14 is a schematic diagram of a film layer structure of a drive backplane of a display panel according to some embodiments of the present disclosure. In the case that the second insulative layer 900 in the display panel 000 is a double film layer structure, that is, includes the inorganic insulative layer 901 and the organic insulative layer 902, and the organic insulative layer 902 is closer to the light-absorbing layer 300 than the inorganic insulative layer 901, a portion of the organic insulative layer 902 extends into the first vias V1 and covers the inner walls of the first vias V1, and/or, a portion of the inorganic insulative layer 602 extends into the first vias V1 and covers the inner walls of the first vias V1.

Illustratively, in FIG. 14, the organic insulative layer 902 and the inorganic insulative layer 901 both include a portion extending into the first vias V, the portion of the organic insulative layer 902 extending into the first vias V1 completely covers the inner walls of the first vias V1, and the portion of the inorganic insulative layer 901 extending into the first vias V1 completely covers a portion of the organic insulative layer 902 facing away from the inner walls of the first vias V1, such that the light-absorbing layer 300 is not exposed.

It should be noted that a portion of the organic insulative layer 902 outside the first vias V1 is in contact with the side, facing away from the substrate 100, of the light-absorbing layer 300, and a portion of the inorganic insulative layer 901 outside the first vias V1 is in contact with the side, facing away from the substrate 100, of the organic insulative layer 902. As such, the portion of the organic insulative layer 902 outside the first vias V1 and the portion of the inorganic insulative layer 901 outside the first vias V1 protect the light-absorbing layer 300 from the side, facing away from the substrate 100, of the light-absorbing layer 300, and the portion of the organic insulative layer 902 in the first vias V1 and the portion of the inorganic insulative layer 901 in the first vias V1 protect the light-absorbing layer 300 from the inner walls of the first vias V1.

As the organic insulative layer 902 is greatly attached to the light-absorbing layer 300, the portion of the organic insulative layer 902 extending into the first vias V1 is closely attached to the inner walls of the first vias V1. In addition, as the inorganic insulative layer 901 has a great moisture-oxygen barrier capability, the moisture and oxygen in the external environment are prevented from eroding the inner structure in the display panel 000 in the case that the inorganic insulative layer 901 wraps and protects the light-absorbing layer 300. As such, the protection effect of the light-absorbing layer 300 is further improved.

In some embodiments, the second metal drive layer 202 in the display panel 000 includes a plurality of second drive signal lines (not shown in drawing). The first metal drive layer 201 in the display panel 000 includes a plurality of first drive signal lines (not shown in drawing) and a plurality of conductive pads S. An extension direction of the first drive signal lines is intersected with an extension direction of the second drive signal lines. For example, the extension direction of the first drive signal lines is perpendicular to the extension direction of the second drive signal lines.

In a plurality of conductive pads S in the first metal drive layer 201, one part of the plurality of conductive pads S are electrically connected to the first drive signal lines, and the other part of the plurality of conductive pads S are electrically connected to the second drive signal lines.

In some embodiments, the display panel further includes a third insulative layer 800 between the second metal drive layer 202 and the first metal drive layer 201. The third insulative layer 800 insulates the second metal drive layer 202 from the first metal drive layer 201 to ensure that the second drive signal lines in the second metal drive layer 202 and the first drive signal lines in the first metal drive layer 201 are not short circuit at the crossing position.

Illustratively, fifth vias V5 are defined in the third insulative layer 800, such that a partial structure of the first metal drive layer 201 is electrically connected to partial structure of the second metal drive layer 202 over the fifth vias V5.

In some embodiments, the third insulative layer 800 in the display panel includes: a second inorganic protection layer 802, an organic planarization layer 803, and a third inorganic protection layer 804 that are laminated in a direction perpendicular to and away from the substrate 100. The second inorganic protection layer 802 covers the second metal drive layer 202, and third sub-vias are defined in the second inorganic protection layer 802. The organic planarization layer 803 is disposed on a side, facing away from the substrate 100, of the second inorganic protection layer 802, and fourth sub-vias in communication with third sub-vias are defined in the organic planarization layer 803. The third inorganic protection layer 804 is disposed on a side, facing away from the substrate 100, of the organic planarization layer 803, a portion of the third inorganic protection layer 804 extends into the third sub-vias and the fourth sub-vias and covers inner walls of the third sub-vias and the fourth sub-vias, and fifth sub-vias are defined in the portion of the third inorganic protection layer 804 extending into the third sub-vias and the fourth sub-vias. As such, the third sub-vias, the fourth sub-vias, and the fifth sub-vias that are in communication with each other form fifth vias V5 of the third insulative layer 800.

It should be noted that for the second inorganic protection layer 802, the second inorganic protection layer 802 isolates the moisture and the oxygen in the external environment, such that the moisture and the oxygen in the external environment do not erode the second metal drive layer 202 from the side, facing away from the substrate 100, of the second metal drive layer 202, and thus the possibility of oxidizing and eroding the second metal drive layer 202 is efficiently reduced.

For the organic planarization layer 803, the organic planarization layer 803 functions as planarization to ensure stable film layer structure that is subsequently formed.

For the third inorganic protection layer 804, as the subsequently formed first metal drive layer 201 needs to be disposed on a side, facing away from the substrate 100, of the third inorganic protection layer 804, the third inorganic protection layer 804 ensures that the moisture and the oxygen in the external environment do not erode the first metal drive layer 201 from the side, facing away from the substrate 100, of the first metal drive layer 201, and thus the possibility of oxidizing and eroding the first metal drive layer 201 is efficiently reduced.

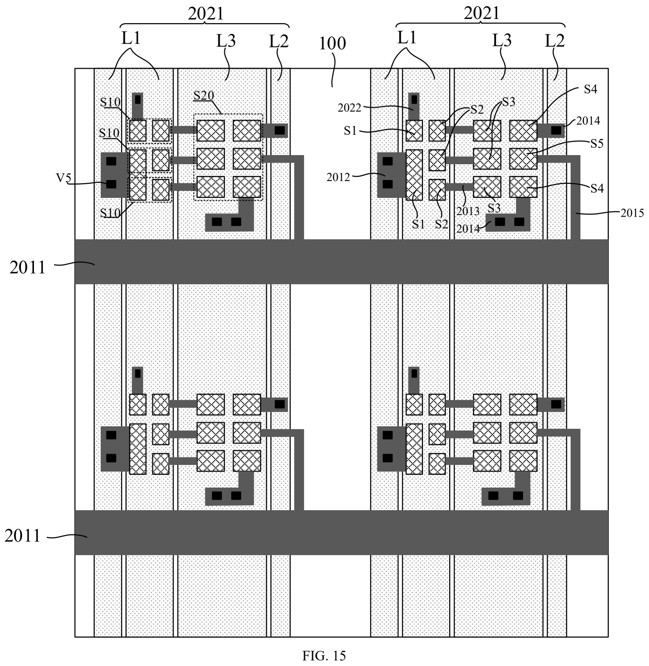

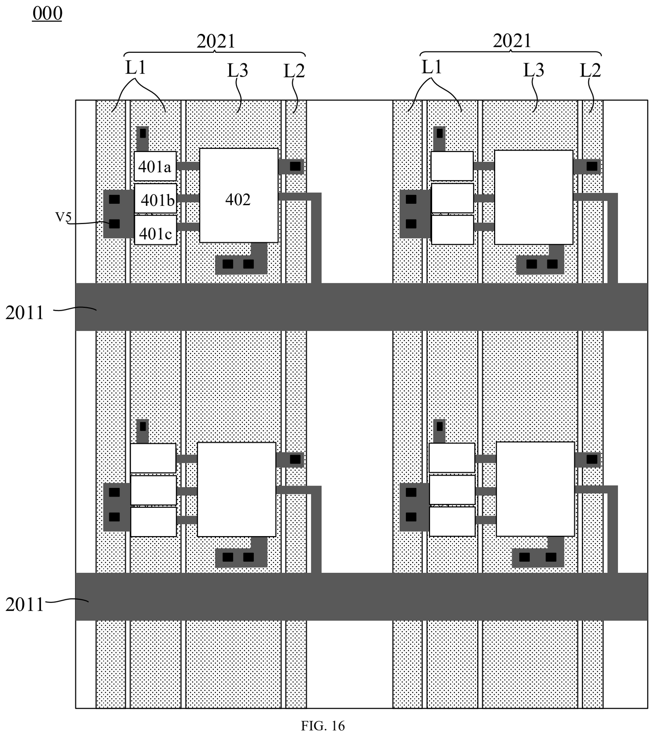

In some embodiments, referring to FIG. 15 and FIG. 16, FIG. 15 is a locally top view of a drive backplane of a display panel according to some embodiments of the present disclosure. FIG. 16 is a locally top view of a display panel according to some embodiments of the present disclosure. The light-emitting units 400 in the display panel 000 are arranged in multiple rows and multiple columns. A plurality of second drive signal lines 2021 in the second metal drive layer 202 include a plurality of sets of second drive signal lines 2021 corresponding to a plurality of columns of light-emitting units 400, and each of the plurality of sets of second drive signal lines 2021 corresponds to one column of light-emitting units 400. A plurality of first drive signal lines 2011 in the first metal drive layer 201 corresponds to a plurality of rows of light-emitting units 400, and each of the plurality of sets of first drive signal lines 2011 corresponds to one row of light-emitting units 400. An orthographic projection of one column of light-emitting units 400 on the substrate 100 is overlapped with an orthographic projection of one corresponding set of second drive signal lines 2021 on the substrate 100, and one row of light-emitting units 400 are disposed between adjacent two first drive signal lines 2011.

Illustratively, one set of second drive signal lines 2021 correspondingly connected to one column of light-emitting units 400 in the display panel 000 include: an anode drive signal line L1, a data signal line L2, and a ground line L3. One first drive signal line 2011 correspondingly connected to one row of light-emitting units 400 is the power signal line.

The light-emitting unit 400 in the display panel 000 includes a drive chip 402 and at least one LED 401. In this case, a plurality of conductive pads S in the first metal drive layer 201 in the display panel 000 include a first pad set S10 fixedly connected to the LED 401 in the light-emitting unit 400, and a second pad set S20 fixedly connected to the drive chip 402 in the light-emitting unit 400. In some embodiments, an orthographic projection of the first pad set S10 on the substrate 100 is within an orthographic projection of the anode drive signal line L1 on the substrate 100, and an orthographic projection of the second pad set S20 on the substrate 100 is within an orthographic projection of the ground line L3 on the substrate 100.

The first pad set S10 includes a first conductive pad S1 and a second conductive pad S2, and the second pad set S20 includes a third conductive pad S3, a fourth conductive pad S4, and a fifth conductive pad S5.

One part of the set of second drive signal lines 2021 electrically connected to the light-emitting units 400 are configured to be electrically connected to the first conductive pad S1 in the first pad set S10. For example, the first metal drive layer 201 further includes a first transfer electrode 2012. The anode drive signal line L1 in the set of second drive signal lines 2021 is electrically connected to the first conductive pad S1 via the first transfer electrode 2012.

The second conductive pad S2 in the first pad set S10 is electrically connected to the third conductive pad S3 in the second pad set S20. For example, the first metal drive layer 201 further includes a second transfer electrode 2013. The first conductive pad S1 is electrically connected to the third conductive pad S3 via the second transfer electrode 2013.

The other part of the set of second drive signal lines 2021 electrically connected to the light-emitting units 400 are configured to be electrically connected to the fourth conductive pad S4 in the second pad set S20. For example, the first metal drive layer 201 further includes a third transfer electrode 2014. The data signal line L2 in the set of second drive signal lines 2021 is electrically connected to one fourth conductive pad S4 via one third transfer electrode 2014, and the ground line L3 in the set of second drive signal lines 2021 is electrically connected to the other conductive pad S4 via the other third transfer electrode 2014.

The first drive signal lines 2021 electrically connected to the light-emitting units 400 are configured to be electrically connected to the fifth conductive pad S5 in the second pad set S20. For example, the first metal drive layer 201 further includes a fourth transfer electrode 2015. The first drive signal lines 2021 are electrically connected to the fifth conductive pad S5 via the fourth transfer electrode 2015.

Illustratively, three LEDs 401 are defined in the light-emitting unit 400. The three LEDs 401 include: a red LED 401a for emitting red light, a green LED 401b for emitting green light, and a blue LED 401c for emitting blue light. In this case, three first pad sets S10 are defined, and the three first pad sets S10 are respectively and electrically connected to the red LED 401a, the green LED 401b, and the blue LED 401c.

The red LED 401a, the green LED 401b, and the blue LED 401c in the light-emitting unit 400 each is provided with two pins, that is, a positive pin and a negative pin.

The positive pin of the red LED 401a is welded to the first conductive pad S1 in the corresponding first pad set S10, such that the positive pin of the red LED 401a is connected to the corresponding anode drive signal line L1 through the first conductive pad S1. The negative pin of the red LED 401a is welded to the second conductive pad S2 in the corresponding first pad set S10.

The positive pin of the green LED 401b is welded to the first conductive pad S1 in the corresponding first pad set S10, such that the positive pin of the green LED 401b is connected to the corresponding anode drive signal line L1 through the first conductive pad S1. The negative pin of the green LED 401b is welded to the second conductive pad S2 in the corresponding first pad set S10.

The positive pin of the blue LED 401c is welded to the first conductive pad S1 in the corresponding first pad set S10, such that the positive pin of the blue LED 401c is connected to the corresponding anode drive signal line L1 through the first conductive pad S1. The negative pin of the blue LED 401c is welded to the second conductive pad S2 in the corresponding first pad set S10.

The drive chip 402 in the light-emitting unit 400 is provided with six pins, that is, a power signal input pin, a data signal input pin, a ground pin, and three signal output pins corresponding to three LEDs.

The three signal output pins of the drive chip 402 are respectively welded to three third conductive pads S3 in the second pad set S10. As the three third conductive pads S3 are electrically connected to three second conductive pads S2 in three first pad sets S10, the three signal output pins of the drive chip 402 are respectively and electrically connected to positive pins of the three LEDs.

The power signal input pin of the drive chip 402 is welded to a fifth conductive pad S5 in the second pad set S20, such that the power signal input pin is connected to the power signal line (that is, the first drive signal line 2011) through the fifth conductive pad S5.

The data signal input pin of the drive chip 402 is welded to one fourth conductive pad S4 in the second pad set S20, such that the data signal input pin is connected to the data signal line through the fourth conductive pad S4.

The ground pin of the drive chip 402 is welded to the other fourth conductive pad S4 in the second pad set S20, such that the ground pin is connected to the ground line L3 through the other fourth conductive pad S4.

In this case, in the case that the display panel 000 needs to control a light-emitting unit 400 to emit light, a power drive signal is supplied to the power signal line electrically connected to the light-emitting unit 400 in the display panel 000, and a data drive signal is supplied to the data signal line L2 electrically connected to the light-emitting unit 400. As such, upon receiving a power drive signal through the power signal input pin, the drive chip 402 in the light-emitting unit 400 is in an operating state. Upon receiving a data signal via the data signal input pin, the drive chip 402 generates three cathode signals corresponding to the three LEDs based on the data signal. The three cathode signals are output to the positive pins of the three LEDs through the three signal output pins. As the positive pin of the LED is always connected to the anode signal supplied by the anode drive signal line L1, the LED emits light with a corresponding intensity upon receiving the anode signal and the cathode signal.

It should be noted that at least two of the positive pin of the red LED 401a, the positive pin of the green LED 401b, or the positive pin of the blue LED 401c are connected to a same anode drive signal line L1 to simplify the line structure of the display panel 000. As the luminescence characteristic of the red LED 401a is greatly different from the luminescence characteristic of the green LED 401b and the luminescence characteristics of the blue LED 401c, and the luminescence characteristic of the green LED 401b is slightly different from the luminescence characteristic of the blue LED 401c, the positive pin of the green LED 401b and the positive pin of the blue LED 401c are connected to a same anode drive signal line L1, and the positive pin of the red LED 401a is connected to another anode drive signal line L1. In this case, the first conductive pad S1 welded to the positive pin of the green LED 401b and the first conductive pad S1 welded to the positive pin of the blue LED 401c are in an integrated structure. That is, the positive pin of the green LED 401b and the positive pin of the blue LED 401c are welded to a same first conductive pad S1, and the positive pin of the red LED 401a is welded to another first conductive pad S1.

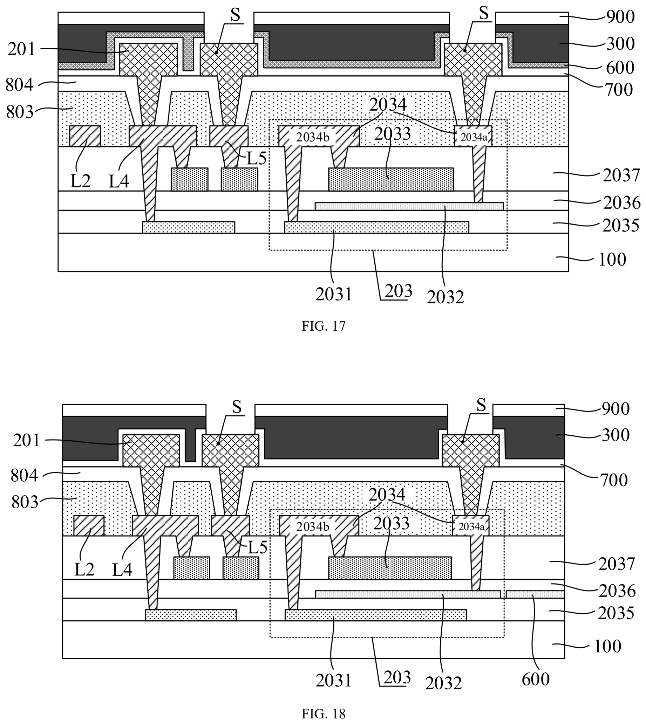

In a third optional implementation, referring to FIG. 17, FIG. 17 is a schematic diagram of a film layer structure of a drive backplane of a display panel according to some embodiments of the present disclosure. The light-reflecting layer 600 in the display panel 000 is disposed on a side, facing away from the substrate 100, of the first metal drive layer 201, and the display panel 000 further includes a plurality of drive circuits 203 on a side, close to the substrate 100, of the first metal drive layer 201. That is, the light-reflecting layer 600 is disposed between the first metal drive layer 201 and the light-absorbing layer 300, and the drive structure layer in the display panel 000 includes a plurality of drive circuits 203.

It should be noted that for the location, the principle, and the material of the light-reflecting layer 600 in this case, reference may be made to corresponding description in the first optional implementation, which are not described again in the embodiments of the present disclosure.

In a fourth optional implementation, referring to FIG. 18, FIG. 18 is a schematic diagram of a film layer structure of a drive backplane of a display panel according to some embodiments of the present disclosure. The light-reflecting layer 600 in the display panel 000 is disposed on a side, close to the substrate 100, of the first metal drive layer 201, and the display panel 000 further includes a plurality of drive circuits 203 on a side, close to the substrate 100, of the first metal drive layer 201. That is, the light-reflecting layer 600 is disposed between the first metal drive layer 201 and the substrate 100, and the drive structure layer in the display panel 000 includes a plurality of drive circuits 203.

Illustratively, the plurality of drive circuits 203 in the display panel 000 are in one-to-one correspondence to the plurality of light-emitting units 400, and each of the plurality of drive circuits 203 is electrically connected to the corresponding light-emitting unit 400 through the conductive pad S in the first metal drive layer 201. Each of the plurality of drive circuits 203 in the display panel 000 includes a plurality of laminated electrical patterns, and the display panel 000 further includes an insulative layer between adjacent two of the plurality of electrical patterns. The insulative layer between adjacent two of the plurality of electrical patterns insulates the two electrical patterns from each other to ensure matching of the electrical patterns in each of the plurality of drive circuits 203, such that the corresponding light-emitting units 400 is driven to emit light.

In this case, the light-reflecting layer 600 in the display panel 000 is disposed on a same layer as one of the plurality of electrical patterns, and an orthographic projection of the light-reflecting layer 600 on the substrate is overlapped with the orthographic projection of the light-absorbing layer 300 on the substrate. As such, in the process of forming a plurality of signal lines D1 in the bonding region F by the laser etching process, the laser irradiated to the bonding region F passes through the substrate 100, and then is completely reflected by the light-reflecting layer 600, such that the laser is not irradiated to the light-absorbing layer 300.

It should be noted that in the case that the light-reflecting layer 600 in the display panel 000 is disposed on a same layer as one of the plurality of electrical patterns, the material of the light-reflecting layer 600 and the material of the electrical pattern are the same or different. In the case that the material of the light-reflecting layer 600 and the material of the electrical pattern are the same, the electrical pattern and the light-reflecting layer 600 are formed by a single patterning process, such that the manufacturing cost of the display panel 000 is efficiently reduced.

In some embodiments, for the third optional implementation and the fourth optional implementation, the display panel 000 drives the light-emitting units 300 in the display panel 000 to emit light under the action of the first metal drive layer 201 and the plurality of drive circuits 203, and the light-emitting unit 400 in the display panel 000 in the architecture includes at least one LED 401. The following embodiments illustrate other structures in the display panel 000 in the architecture.

As shown in FIG. 17 and FIG. 18, the plurality of electrical patterns in each drive circuit 203 in the display panel 000 include a first gate pattern 2031, an active layer pattern 2032, a second gate pattern 2033, and a source-drain pattern 2034 that are laminated in a direction perpendicular to and away from the substrate 100. The display panel 000 further includes a first gate insulative layer 2035 between the first gate pattern 2031 and the active layer pattern 2032, a second gate insulative layer 2036 between the second gate pattern 2033 and the active layer pattern 2032, and an interlayer dielectric layer between the second gate pattern 2033 and the source-drain pattern 2034.

The drive circuit 203 includes at least one transistor, and the first gate pattern 2031, the active layer pattern 2032, the second gate pattern 2033, and the source-drain pattern 2034 in the drive circuit 203 form the transistor. The at least one transistor is a dual-gate transistor.

Illustratively, an orthographic projection of the first gate pattern 2031 on the substrate 100 and an orthographic projection of the second gate pattern 2033 on the substrate 100 are overlapped with an orthographic projection of the active layer pattern 2032 on the substrate 100, the first gate pattern 2031 is illustrated from the active layer pattern 2032 by the first gate insulative layer 2035, and the second gate pattern 2033 is illustrated from the active layer pattern 2032 by the second gate insulative layer 2046. The source-drain pattern 2034 includes a first electrode 2034a and a second electrode (not marked in the drawing) lapped with the active layer pattern 2032, and a lap electrode 2034b separated from the first electrode and the second electrode. The first electrode 2034a is one of the source and the drain, and the second electrode is the other of the source and the drain. The lap electrode 2034b is respectively and electrically connected to the first gate pattern 2031 and the second gate pattern 2033 through a first lap via V10 and a second lap via V20. As such, the first gate pattern 2031 and the second gate pattern 2033 supply a same potential on the active layer pattern 2033 to cause the first electrode 2034a and the second electrode lapped with the active layer pattern 2033 to be turned on or off.

In some embodiments, the drive electrode layer in the display panel 000 further includes a plurality of drive signal lines electrically connected to the drive circuits 203. Illustratively, the plurality of drive signal lines electrically connected to the drive circuits 203 include: a data signal line L2, a high level voltage signal line L4, and a low level voltage signal line L5. The light-emitting units 400 include a red LED, a green LED, and a blue LED, and include a plurality of conductive pins electrically connected to the LEDs. One part of the plurality of conductive pins are electrically connected to the drive signal lines through the corresponding conductive pads S in the first metal drive layer 201, and the other of the plurality of conductive pins are electrically connected to the drive circuits 203 through the corresponding conductive pads S in the first metal drive layer 201. As such, the luminous state and the luminous intensity of each LED in the corresponding light-emitting unit 300 are controlled by matching of the drive signal lines and the drive circuits 203.

In the embodiments of the present disclosure, the display panel 000 further includes: an organic planarization layer 803 on a side, facing away from the substrate 100, of the plurality of drive circuits 203, a third inorganic protection layer 804 between the organic planarization layer 803 and the first metal drive layer 201, a first insulative layer 700 between the first metal drive layer 201 and the light-absorbing layer 300, and a second insulative layer 900 on a side, facing away from the substrate 100, of the light-absorbing layer 300. For structures and features of the insulative layers, reference may be made to corresponding description in the above embodiments, which are not described again herein.

It should be noted that a material of the light-reflecting layer 600 in the display panel 000 and a material of the electrical pattern on a same layer are the same or different, and thus embodiments of the present disclosure are illustrated by taking following two examples as an example.

In a first example, in the case that the material of the light-reflecting layer 600 in the display panel 000 and the material of the electrical pattern on a same layer are different, the material of the light-reflecting layer 600 is the amorphous silicon or the white ink, and the light-reflecting layer 600 is disposed in a same layer as any of the plurality of electrical patterns in the drive circuit 203.

In a second example, in the case that the material of the light-reflecting layer 600 in the display panel 000 and the material of the electrical pattern on a same layer are the same, the light-reflecting layer 600 and the electrical pattern are disposed on a same layer with a same material, and are formed by a single patterning process, such that the manufacturing process of the display panel 000 is efficiently simplified.

Illustratively, the light-reflecting layer 600 and the active layer pattern 2032 in the drive circuit 203 are disposed on a same layer. In this case, the material of the active layer pattern 2032 and the material of the light-reflecting layer 600 are the same, for example, the low-temperature polycrystalline silicon. As the low-temperature polycrystalline silicon is a material with reflective property and semiconductor property, the low-temperature polycrystalline silicon is used as the active layer pattern 2032 in the transistor based on the semiconductor property of the low-temperature polycrystalline silicon, and the low-temperature polycrystalline silicon is used as the light-reflecting layer 600 based on the reflective property of the low-temperature polycrystalline silicon.

The embodiments of the present disclosure illustrate locations of the light-reflecting layer 600 in the display panel 000 in the case that the light-reflecting layer 600 and the active layer pattern 2032 are disposed on a same layer with a same material.

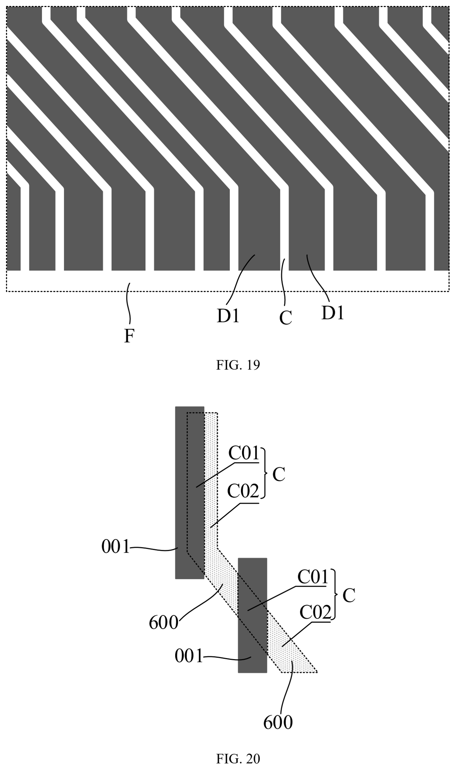

As shown in FIG. 19, FIG. 19 is a locally enlarged diagram of a display panel from a back face according to some embodiments of the present disclosure. An edge of a face, facing away from the first metal drive layer 201, of the substrate 100 in the display panel 000 includes a bonding region F, and at least part of a plurality of signal lines D1 in the bonding region F are electrically connected to the drive circuit 203. In the bonding region F, a region between adjacent two signal lines D1 is a spacer region C. In the process of forming the plurality of signal lines D1 in the bonding region F by the laser etching process, the laser needs to be irradiated to the spacer region C, such that a metal portion in the spacer region C is etched under the irradiation of the laser. An orthographic projection of the light-reflecting layer 600 on the substrate 100 is overlapped with an orthographic projection of the spacer region C on the substrate 100.

In the present disclosure, for front distribution illustration of the spacer region C between adjacent two signal lines D1 in the display panel 400, reference may be made to FIG. 20. FIG. 20 is a locally schematic diagram of a single spacer region in a display panel from a front face according to some embodiments of the present disclosure. The spacer region C may include a region not covered by the first metal drive layer 201 and a plurality of electrical patterns in the drive circuit 203 in the display panel 000. The light-reflecting layer 600 in the same layer as the active layer pattern 2032 with the same material at least needs to be disposed in the region to ensure that the laser passing through the substrate 100 through the spacer region C is blocked by the light-reflecting layer 600, and thus the laser is not irradiated to the light-absorbing layer 300.

Illustratively, the spacer region C between adjacent two signal lines D1 includes a first region C01 and a second region C02.

The first region C01 is a region in the spacer region C covered by the first metal drive layer 201 and a plurality of electrical patterns in the drive circuit 203, and the second region C02 is a region in the spacer region other than the first region C01. It should be noted that in FIG. 20, the black region represents the region covered by the first metal drive layer 201 and the plurality of electrical patterns in the drive circuit 203.

In the present disclosure, the orthographic projection of the light-reflecting layer 600 on the substrate 100 is at least partially within an orthographic projection of the second region C02 on the substrate 100. As such, the laser transmitted through the second region C02 in the spacer region C is blocked by the light-reflecting layer 600, and thus is not irradiated to the light-absorbing layer 300.

It should be noted that as the first region C01 in the spacer region C is covered by the first metal drive layer 201 and a plurality of electrical patterns in the drive circuit 203, the laser transmitted through the first region C01 in the spacer region C is blocked by the first metal drive layer 201 and the plurality of electrical patterns in the drive circuit 203, and thus is not irradiated to the light-absorbing layer 300.

Illustratively, the orthographic projection of the light-reflecting layer 600 on the substrate 100 is not coincident with the orthographic projection of the first metal drive layer 201 on the substrate 100 and the orthographic projections of the electrical patterns in the drive circuit 203 on the substrate 100. That is, the orthographic projection of the light-reflecting layer 600 on the substrate 100 is not coincident with the orthographic projection of the first region C01 in the spacer region C on the substrate 100. In this case, in the case that the light-reflecting layer 600 and an electrical pattern in the drive circuit 203 are disposed in a same layer and made of a same material, no parasitic capacitance is present between the light-reflecting layer 600 and the nearby electrical pattern, and thus the signal inside the display panel 000 is less affected by parasitic capacitance interference.

Illustratively, as shown in FIG. 20, the orthographic projection of the light-reflecting layer 600 on the substrate 100 completely covers the second region C02 in the spacer region C. The laser transmitted through various positions in the second region C02 in the spacer region C is blocked by the light-reflecting layer 600, such that the laser is not irradiated to the light-absorbing layer 300.

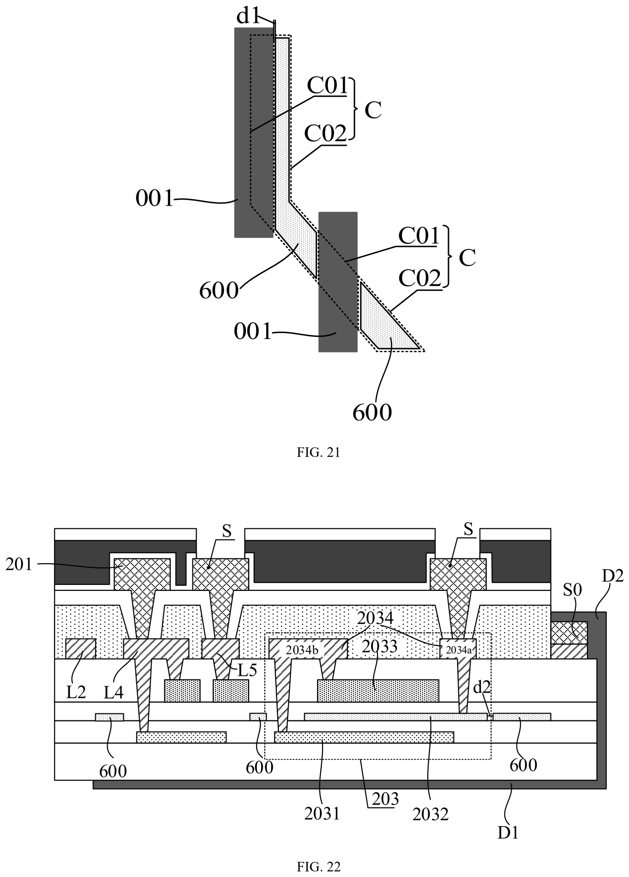

Illustratively, as shown in FIG. 21, FIG. 21 is a locally schematic diagram of a single spacer region of a display panel from a front face according to some embodiments of the present disclosure. A boundary of an orthographic projection of a portion of the light-reflecting layer 600 covered by the second region C02 in the spacer region C on the substrate 100 extends along a boundary of an orthographic projection of the first region C01 in the spacer region C on the substrate 100, and is not coincident with the boundary of the orthographic projection of the first region C01 in the spacer region C on the substrate 100. A width of a spacing d1 between the two boundaries is less. For example, a maximum width of the spacing d1 between the two boundaries is less than or equal to 15 microns. As such, even though the laser irradiated to the spacer region C passes through the spacing d1 between the two boundaries and transmits to the light-absorbing layer 300, the energy of the laser irradiated to the light-absorbing layer 300 is less, such that the light-absorbing layer 300 does not exhibit bubbling. For example, the maximum width of the spacing d1 between the two boundaries is less than or equal to 5 microns.

Illustratively, as shown in FIG. 22, FIG. 22 is a schematic diagram of a film layer structure of a drive backplane of a display panel according to some embodiments of the present disclosure. The orthographic projection of the light-reflecting layer 600 on the substrate 100 is not coincident with the orthographic projection of the first region on the substrate 100. In this case, the orthographic projection of the light-reflecting layer 600 on the substrate 100 is not coincident with the orthographic projection of the first metal drive layer 201 on the substrate 100, and is not coincident with the orthographic projections of the electrical patterns in the drive circuit 203 on the substrate 100. In this case, as the light-reflecting layer 600 and the active layer pattern 2032 are disposed in the same layer with the same material, and the material of the light-reflecting layer 600 is the low-temperature polycrystalline silicon with the semiconductor property, in the case that the orthographic projection of the light-reflecting layer 600 on the substrate 100 is not coincident with the orthographic projection of the first metal drive layer 201 on the substrate 100, and is not coincident with the orthographic projections of the first gate pattern 2031, the second gate pattern 2033, and the source-drain pattern 2034 in the drive circuit 203 on the substrate 100, the first metal drive layer 201, the first gate pattern 2031, the second gate pattern 2033, and the source-drain pattern 2034 have no electrical interference on the light-reflecting layer 600, such that the light-reflecting layer 600 is always in a non-conductive state, and thus the parasitic capacitance between the light-reflecting layer 600 and the nearby metal structure is less.

In some embodiments, the orthographic projection of the light-reflecting layer 600 on the substrate 100 is overlapped with the orthographic projection of the first region on the substrate 100, and an area of an overlapped region is less. For example, a maximum width of the overlapped region of the orthographic projection of the light-reflecting layer 600 on the substrate 100 and the orthographic projection of the first region on the substrate 100 is less than 5 microns.

In some embodiments, as shown in FIG. 22, in the case that the light-reflecting layer 600 and the active layer pattern 2032 are disposed in the same layer with the same material, a minimum distance d2 between an outer boundary of the orthographic projection of the active layer pattern 2032 on the substrate 100 and the orthographic projection of the light-reflecting layer 600 on the substrate 100 needs to be greater than or equal to 5 microns, such that the light-reflecting layer 600 in the same layer as the active layer pattern 2032 with the same material does not affect normal operation of the active layer pattern 2032.

It should be noted that the active layer pattern 2032 in each pixel circuit 203 in the display panel 000 is an island-like pattern. Each island-like pattern includes a continuously-distributed inner region and a contour edge around the inner region, and the contour edge is the outer boundary of the orthographic projection of the active layer pattern 2032 on the substrate 100.

In the embodiments of the present disclosure, as shown in FIG. 22, the display panel 000 further includes a transfer pad S0 electrically connected to the pixel circuit 203. One end of the connection line D2 is lapped with a side, facing away from the substrate, of the transfer pad S0, and the other end of the connection line D2 is electrically connected to the signal line D1, such that the drive assemblies bonded in the bonding region F are sequentially and electrically connected to the drive circuits 203 over the signal line D1, the connection line D2, and the transfer pad S0.

In some embodiments, for the fourth optional implementation, as shown in FIG. 10, the display panel 000 further includes mark patterns M in a same layer as at least one of the plurality of electrical patterns with a same material, and avoidance holes K corresponding to the mark patterns M are defined in the light-reflecting layer 600 in the display panel. Orthographic projections of the avoidance holes K on the substrate 100 are overlapped with orthographic projections of the mark patterns M on the substrate 100. Illustratively, the orthographic projections of the mark patterns M on the substrate 100 are within the orthographic projections of the avoidance holes K on the substrate 100.

In the present disclosure, in the case that the light-reflecting layer 600 and the active layer pattern 2032 are disposed in the same layer, at least two mark patterns M are defined in the display panel 000, one of the at least two mark patterns M is disposed in a same layer as the second gate pattern 2033 with a same material, and the other of the at least two mark patterns M is disposed in a same layer as the source-drain pattern 2034 with a same material. At least two avoidance holes K in one-to-one correspondence to the at least two mark patterns M are defined in the light-reflecting layer 600, and an orthographic projection of each mark pattern M on the substrate 100 is within an orthographic projection of the corresponding avoidance hole K on the substrate 100.

It should be noted that for reasons of disposing the mark patterns M in the display panel 000 and defining corresponding avoidance holes K in the light-reflecting layer 600, reference may be made to corresponding portions in the above embodiments, which are not described again in the embodiments of the present disclosure. It should be further noted that the display panel 000 further includes auxiliary mark patterns in a same layer as the first gate pattern 2031 and the active layer pattern 2032 with a same material, the auxiliary mark patterns are not blocked by the light-reflecting layer 600, and thus avoidance holes corresponding to the auxiliary mark patterns are not required in the light-reflecting layer 600.

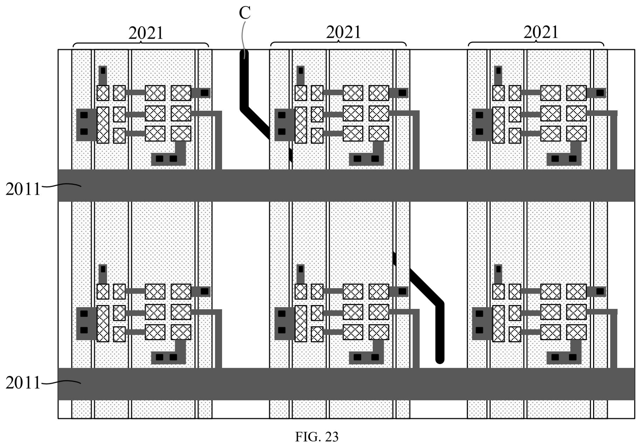

It should be further noted that for the first optional implementation and the second optional implementation, that is, the display panel 000 simultaneously includes the first metal drive layer 201 and the second metal drive layer 202, for front distribution illustration of the spacer region C between adjacent two signal lines D1 in the bonding region F in the display panel 400, reference may be made to FIG. 23. FIG. 23 is a locally enlarged diagram of a display panel from a front face according to some embodiments of the present disclosure. The spacer region C may also include a region not covered by the first metal drive layer 201 and the second metal drive layer 202. As such, in the case that the laser is irradiated to the spacer region C, the laser transmits to the light-absorbing layer 300 by passing through the substrate 100, the second metal drive layer 202, and the first metal drive layer 201. In the case that the light-reflecting layer 600 is disposed between the substrate 100 and the light-absorbing layer 300, the light-reflecting layer 600 reflects the laser, such that the laser is not irradiated to the light-absorbing layer 300, and thus the light-absorbing layer 300 does not exhibit bubbling.

In the case that the material of the light-reflecting layer 600 is the amorphous silicon or the low-temperature polycrystalline silicon, as reflectivity of the amorphous silicon of different thicknesses to the laser of different wavebands is diverse, a thicker light-reflecting layer 600 is used in the case that a longer wavelength laser is used in the process of forming a plurality of signal lines D1 by the laser etching process, such that the light-reflecting layer 600 has the great reflectivity to the laser. For example, the thickness of the light-reflecting layer 600 ranges from 1100 angstroms to 2000 angstroms. In the case that a shorter wavelength laser is used in the process of forming a plurality of signal lines D1 by the laser etching process, a thinner light-reflecting layer 600 is used, such that the light-reflecting layer 600 has the great reflectivity to the laser. For example, the thickness of the light-reflecting layer 600 ranges from 500 angstroms to 1100 angstroms.

In the embodiments of the present disclosure, in addition to disposing the light-reflecting layer 600, other structures in the display panel 000 are optimized to avoid bubble of the light-absorbing layer 300 due to irradiation of the laser to the light-absorbing layer 300. Following embodiments illustrate three implementations for optimizing other structures in the display panel 000 by taking the display panel 000 simultaneously including the first metal drive layer 201 and the second metal drive layer 202 as an example.

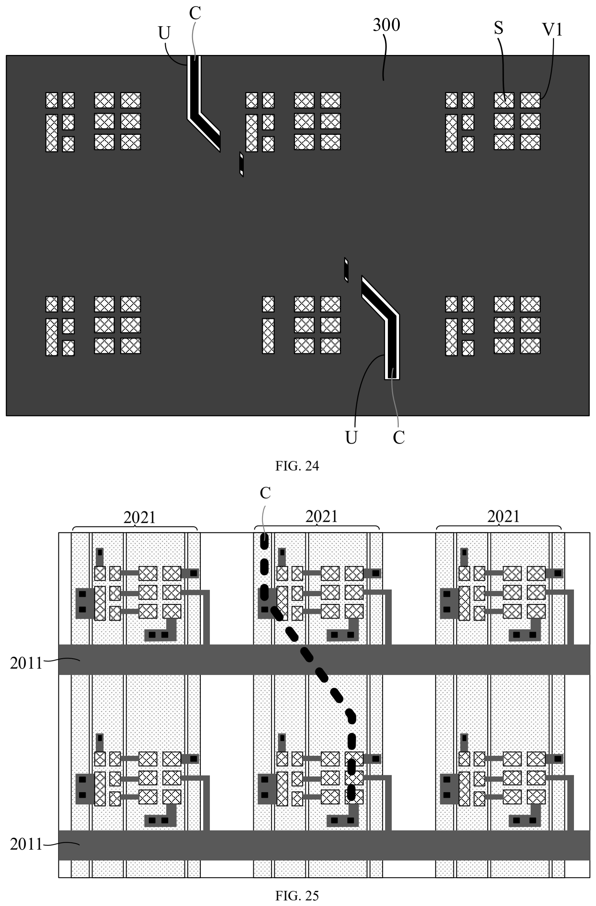

In a first implementation, the structure of the light-absorbing layer 300 in the display panel 000 is optimized. Referring to FIG. 24, FIG. 24 is a locally enlarged diagram of a display panel from a front face according to some embodiments of the present disclosure. It should be noted that the display panel 000 shown in FIG. 24 only shows the structure of the light-absorbing layer 300, and the top views or locally schematic diagrams of the front face of other display panel in the above embodiments do not show the light-absorbing layer 300. The light-absorbing layer 300 in the display panel is provided with auxiliary grooves U, and orthographic projections of the auxiliary grooves U on the substrate 100 are overlapped with the portion not covered by the first metal drive layer 201 and the second metal drive layer 202 in the orthographic projection of the spacer region C on the substrate 100. The orthographic projections of the auxiliary grooves U in the light-absorbing layer 300 on the substrate 100 are not coincident with the orthographic projection of the first metal drive layer 201 on the substrate 100 and the orthographic projection of the second metal drive layer 202 on the substrate 100.

Illustratively, the portion not covered by the first metal drive layer 201 and the second metal drive layer 202 in the orthographic projection of the spacer region C on the substrate 100 is within the orthographic projections of the auxiliary grooves U on the substrate 100. As such, the light-absorbing layer 300 blocks the first metal drive layer 201 and the second metal drive layer 202 from the front face of the display panel 000 to ensure the low reflectivity of the display panel 000 to the ambient light, and the laser irradiated to the spacer region C is not irradiated to the light-absorbing layer 300 upon passing through the substrate 100, the first metal drive layer 201, and the second metal drive layer 202, such that the possibility of bubble of the light-absorbing layer 300 is further reduced.

In the present disclosure, as shown in FIG. 24, a first end portion, close to an edge of the display panel 000, of the spacer region C is generally disposed between adjacent two sets of second drive signal lines 2021, and extends in a polygonal line. As such, the portion in the light-absorbing layer 300 between adjacent two sets of second drive signal lines 2021 needs auxiliary grooves U extending in the polygonal line, and the auxiliary grooves U needs to cover the first end portion of the spacer region C.

Similarly, a second end portion, facing away from the edge of the display panel 000, of the spacer region C is generally disposed between another adjacent two sets of second drive signal lines 2021, and extends in a straight line. As such, the portion in the light-absorbing layer 300 between another adjacent two sets of second drive signal lines 2021 needs auxiliary grooves U extending in the straight line, and the auxiliary grooves U needs to cover the second end portion of the spacer region C.

In some embodiments, as shown in FIG. 23 and FIG. 24, a region between the first end portion and the second end portion in the spacer region C crosses one set of second drive signal lines 2021. A region not covered by the first metal drive layer 201 is present in a space region between adjacent two second drive signal lines 2021 in the one set of second drive signal lines 2021. As such, a region not covered by the first metal drive layer 201 and the second metal drive layer 202 is also present between the first end portion and the second portion in the spacer region C. The portion between adjacent two second drive signal lines 2021 in the light-absorbing layer 300 is provided with the auxiliary grooves U, and the auxiliary grooves U cover an overlapped region of the spacer region C and the space region.

It should be noted that, in some embodiments, as a width of the space region between adjacent two second drive signal lines 2021 in the one set of second drive signal lines 2021 is less, for example, about 15 microns, in the process of forming the plurality of signal lines D1 in the bonding region F by the laser etching process, even though the laser passes through the substrate 100 and is irradiated to the light-absorbing layer 300 upon passing through the space region between adjacent two second drive signal lines 2021 in the one set of second drive signal lines 2021, the energy of the laser passing through the space region is less as the width of the space region is less, and thus the light-absorbing layer 300 does not exhibit bubbling even though the laser is irradiated to the light-absorbing layer 300. Thus, the auxiliary grooves U are defined in the portion between adjacent two second drive signal lines 2021 in the light-absorbing layer 300.

In the embodiments of the present disclosure, a shape of the auxiliary groove U in the light-absorbing layer 300 is coincident with a shape of the portion of the spacer region C not covered by the first metal drive layer 201 and the second metal drive layer 202. As such, the laser irradiated to the spacer region C is not irradiated to the light-absorbing layer 300 without defining a large-sized auxiliary groove U in the light-absorbing layer 300. Thus, the area of the auxiliary groove U in the light-absorbing layer 300 is less, and thus the probability of color cast in the display panel 000 due to the large-sized groove in the light-absorbing layer 300 is reduced.

It should be noted that in the process of forming various film layers on the substrate 100, an offset is present between a location of the film layer structure on the substrate 100 and a designed location due to a manufacturing error of the film layer structure. Thus, in the designing process, a distance is present between a boundary of the auxiliary groove U and an adjacent boundary in the spacer region C to ensure that the auxiliary groove U completely covers the portion of the spacer region C not covered by the first metal drive layer 201 and the second metal drive layer 202. Illustratively, the distance is greater than or equal to 10 microns to ensure that the auxiliary groove U in the eventually formed display panel 000 completely covers the portion of the spacer region C not covered by the first metal drive layer 201 and the second metal drive layer 202 even though the manufacturing error is present in the film layer structure in the substrate 100.

It should be further noted that a small portion of an orthographic projection of the portion of the spacer region C not covered by the first metal drive layer 201 and the second metal drive layer 202 on the substrate 100 is beyond an orthographic projection of the auxiliary groove U on the substrate 100. That is, the spacer region C includes a portion not covered by the first metal drive layer 201, the second metal drive layer 202, and the auxiliary groove U, and a maximum width of an orthographic projection of the portion of the spacer region C not covered by the first metal drive layer 201, the second metal drive layer 202, and the auxiliary groove U on the substrate 100 is less, for example, less than or equal to 15 microns, such that the energy of the laser irradiated to the spacer region C is less upon passing through the substrate 100, the second metal drive layer 202, and the first metal drive layer 201 and then irradiated to the light-absorbing layer 300. The width of the orthographic projection of the portion of the spacer region C not covered by the first metal drive layer 201, the second metal drive layer 202, and the auxiliary groove U on the substrate 100 indicates a width of the orthographic projection in any direction. Thus, a maximum of the width of the orthographic projection in any direction is the maximum of the orthographic projection.

In a second implementation, an arrangement location and a shape of the spacer region C between adjacent two signal lines D1 in the bonding region F are optimized to cause the spacer region C is completely covered by the first metal drive layer 201 and the second metal drive layer 202. One portion of the spacer region C is covered by the first metal drive layer 201, and another portion of the spacer region C is covered by the second metal drive layer 202, such that the laser irradiated in the spacer region C is blocked by the second metal drive layer 202 or the first metal drive layer 201, and thus is not irradiated to the light-absorbing layer 300.

It should be noted that in the present disclosure, the arrangement location of the spacer region C is optimized, and the shape of the spacer region C is also optimized, such that the mode of complete cover of the spacer region C by the first metal drive layer 201 is diverse. The embodiments of the present disclosure illustrate the following to cases.

In a first case, the arrangement location of the spacer region C is optimized. Referring to FIG. 25, FIG. 25 is a locally enlarged diagram of a display panel from a front face according to some embodiments of the present disclosure. An orthographic projection of the spacer region C between adjacent two signal lines D1 on the substrate 100 is within an orthographic projection of a region of a set of second drive signal lines 2021 on the substrate 100. As such, one portion of the spacer region C is covered by the second drive signal lines 2021 in the second metal drive layer 202, and another portion of the spacer region C is covered by the first metal drive layer 201.

Illustratively, a space region is present between adjacent two of the set of second drive signal lines 2021. An overlapped portion of the orthographic projection of the spacer region C on the substrate 100 and an orthographic projection of the space region on the substrate 100 is covered by the first metal drive layer 201. Illustratively, the overlapped portion of the orthographic projection of the spacer region C on the substrate 100 and an orthographic projection of the space region on the substrate 100 is covered by at least one of the first drive signal line 2011 or the transfer electrode (for example, the first transfer electrode 2012) in the first metal drive layer 201.

It should be noted that at least one of the first drive signal line 2011 or the transfer electrode is widened to ensure that the first metal drive layer 201 completely covers the overlapped portion of the spacer region C and the space region. In addition, in the designing process, a minimum distance between a metal portion in the first metal drive layer 201 and the second metal drive layer 202 and the spacer region C is greater than or equal to 10 microns, such that the first metal drive layer 201 and the second metal drive layer 202 in the eventually formed display panel 000 completely cover the spacer region C in the case that the manufacturing error is present in the film layer structure in the substrate 100.

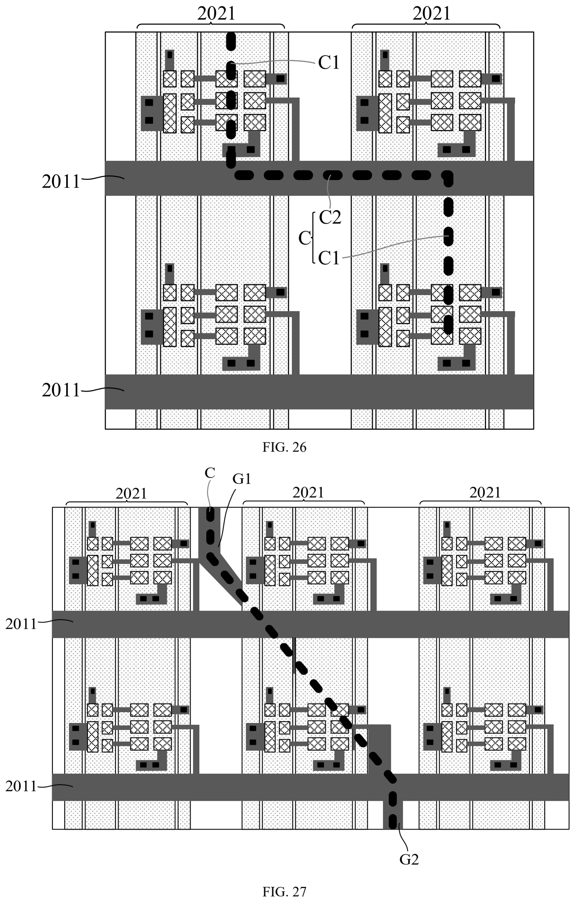

In a second case, the shape of the spacer region C is optimized. Referring to FIG. 26, FIG. 26 is a locally enlarged diagram of a display panel from a front face according to some embodiments of the present disclosure. The spacer region C between adjacent two signal lines D1 includes two first strip sub-regions C1 and a second strip sub-region C2 between the two first strip sub-regions C1. Two ends of the second strip sub-region C2 are respectively connected to the two first strip sub-regions C1. In the two first strip sub-regions C1, one first strip sub-region C1 is disposed on a side, close to the edge of the display panel 000, of the spacer region C, and the other first strip sub-region C2 is disposed on a side, facing away from the edge of the display panel 000, of the spacer region C.

An extension direction of the first strip sub-regions C1 is parallel to an extension direction of the second drive signal lines 2021, and the two first strip sub-regions C1 in the spacer region C are respectively covered by two second drive signal lines 2021. An extension direction of the second strip sub-region C2 is parallel to the extension direction of the second drive signal lines 2021, and the second strip sub-region C2 is covered by a second drive signal lines 2012.

Illustratively, as a width of the ground line L3 in a set of second drive signal lines 2021 is great, for two first strip sub-regions C1 in the spacer region C, one first strip sub-region C1 is covered by the ground line L3 in a set of second drive signal lines 2021, and the other first strip sub-region C1 is covered by the ground line L3 in an adjacent set of second drive signal lines 2021.

It should be noted that in the designing process, a distance between a boundary of the first strip sub-region C1 and an adjacent boundary of the second drive signal line 2021 needs to be greater than or equal to 10 microns, and a distance between a boundary of the second strip sub-region C2 and an adjacent boundary of the second drive signal line 2021 needs to be greater than or equal to 10 microns, such that the first metal drive layer 201 and the second metal drive layer 202 in the eventually formed display panel 000 completely cover the spacer region C in the case that the manufacturing error is present in the film layer structure in the substrate 100.

In a third case, structures of the first metal drive layer 201 and the second metal drive layer 202 in the display panel 000 are optimized, such that the spacer region C is completely covered by the first metal drive layer 201. Illustratively, an area of the orthographic projection of the first metal drive layer 201 on the substrate 100 is increased, such that a portion of the spacer region C not covered by the second metal drive layer 202 previously is covered by the newly increased metal portion of the first metal drive layer 201.

Referring to FIG. 27, FIG. 27 is a locally enlarged diagram of a display panel from a front face according to some embodiments of the present disclosure. For the spacer region C between adjacent two signal lines D1, a first end portion, close to the edge of the display panel 000, of the spacer region C is disposed between adjacent two sets of second drive signal lines 2021, and a second end portion, facing away from the edge of the display panel 000, of the spacer region C is disposed between another adjacent two sets of second drive signal lines 2021. The first metal drive layer 201 further includes a first auxiliary electrode G1 and a second auxiliary electrode G2. The first end portion, close to the edge of the display panel 000, of the spacer region C is covered by the first auxiliary electrode G1, and the second end portion, facing away from the edge of the display panel 000, of the spacer region C is covered by the second auxiliary electrode G2.

In the present disclosure, the first end portion, close to the edge of the display panel 000, of the spacer region C extends in a polygonal line, and thus the first auxiliary electrode G1 covering the first end portion also extends in the polygonal line. The second end portion, facing away from the edge of the display panel 000, of the spacer region C extends in a straight line, and thus the second auxiliary electrode G2 covering the second end portion also extends in the straight line.

In some embodiments, as shown in FIG. 27, a region of the spacer region C between the first end portion and the second end portion crosses a set of second drive signal lines 2021, and a space region is present between adjacent two of the set of second drive signal lines 2021. An overlapped portion of an orthographic projection of the spacer region C on the substrate 100 and an orthographic projection of the space region on the substrate 100 is covered by the first metal drive layer 201. Illustratively, the overlapped portion of the orthographic projection of the spacer region C on the substrate 100 and the orthographic projection of the space region on the substrate 100 is covered by at least one of the first drive signal line 2011 or the transfer electrode (for example, the first transfer electrode 2012) in the first metal drive layer 201.

It should be noted that at least one of the first drive signal line 2011 or the transfer electrode is widened to ensure that the first metal drive layer 201 completely covers the overlapped portion of the spacer region C and the space region. In addition, in the designing process, a minimum distance between a metal portion in the first metal drive layer 201 and the spacer region C is greater than or equal to 10 microns, such that the first metal drive layer 201 in the eventually formed display panel 000 completely cover the spacer region C in the case that the manufacturing error is present in the film layer structure in the substrate 100.

In some embodiments, the first auxiliary electrode G1 and the second auxiliary electrode G2 added in the first metal drive layer 201 need to be electrically connected to a signal transmission structure in the first metal drive layer 201. Illustratively, as shown in FIG. 23, the first auxiliary electrode G1 is electrically connected to a fourth transfer electrode 2015 in the first metal drive layer 201, and the second auxiliary electrode G2 is electrically connected to a first drive signal line 2011 in the first metal drive layer 201. As such, in manufacturing the display panel 000, accumulated charges in the first auxiliary electrode G1 and the second auxiliary electrode G2 are conducted to the signal transmission structure, such that the first auxiliary electrode G1 and the second auxiliary electrode G2 do not accumulate charges separately, and thus electrostatic breakdown at locations where excessive charges are accumulated in the first auxiliary electrode G1 and the second auxiliary electrode G2 is avoided.

It should be further noted that in some embodiments, for the second implementation and the third implementation, as the width of the space region between adjacent two second drive signal lines 2021 in the one set of second drive signal lines 2021 is less, in the process of forming the plurality of signal lines D1 in the bonding region F by the laser etching process, even though the laser passes through the substrate 100 and is irradiated to the light-absorbing layer 300 upon passing through the space region between adjacent two second drive signal lines 2021 in the one set of second drive signal lines 2021, the energy of the laser passing through the space region is less as the width of the space region is less, and thus the light-absorbing layer 300 does not exhibit bubbling even though the laser is irradiated to the light-absorbing layer 300. Thus, the structure of the first metal drive layer 201 may be not widened. As such, the light-absorbing layer 300 does not exhibit bubbling even though the first metal drive layer 201 does not cover the overlapped portion of the spacer region C and the space region.

It is understandable that the most portion of the spacer region C is completely covered by the first metal drive layer 201 and the second metal drive layer 202, a small portion (for example, the overlapped portion of the spacer region C and the space region) of the spacer region C is not covered by the first metal drive layer 201 and the second metal drive layer 202, and the maximum width of the orthographic projection of the portion of the spacer region C not covered by the first metal drive layer 201 and the second metal drive layer 202 on the substrate 100 needs to be less. For example, the maximum width of the orthographic projection of the portion of the spacer region C not covered by the first metal drive layer 201 and the second metal drive layer 202 on the substrate 100 needs to be less or equal to a predetermined width threshold, for example, 15 microns. That is, the maximum width of the orthographic projection of the portion of the spacer region C not covered by the first metal drive layer 201 and the second metal drive layer 202 on the substrate 100 needs to be less or equal to 15 microns, such that the energy of the laser irradiated to the spacer region C is less upon passing through the substrate 100, the second metal drive layer 202, and the first metal drive layer 201 and then irradiated to the light-absorbing layer 300.

The width of the orthographic projection of the portion of the spacer region C not covered by the first metal drive layer 201 and the second metal drive layer 202 on the substrate 100 indicates a width of the orthographic projection in any direction. Thus, a maximum of the width of the orthographic projection in any direction is the maximum of the orthographic projection.

In summary, the display panel according to the embodiments of the present disclosure includes a substrate, a first metal drive layer, a light-absorbing layer, an auxiliary light-absorbing layer, and a plurality of light-emitting units. An orthographic projection of the light-absorbing layer on the substrate is overlapped with an orthographic projection of the drive layer on the substrate. As such, the light-absorbing layer absorbs ambient light irradiated to the display panel, such that reflection of the ambient light irradiated to the display panel by the drive layer is less, and reflectivity of the display panel to the ambient light is low. The reflectivity of the display panel to the ambient light is reduced by disposing the light-absorbing layer in the display panel. Thus, a transmittance of the auxiliary light-absorbing layer on a side, facing away from the substrate, of the plurality of light-emitting units is appropriately improved, such that absorptivity of the auxiliary light-absorbing layer to the light is low, and light emitted by the light-emitting units and absorbed by the auxiliary light-absorbing layer is less. As such, an overall display brightness of the display panel is higher even in the case that the display panel does not supply a large drive current to the light-emitting units, and thus power consumption of the display panel is effectively reduced. In addition, by disposing the light-reflecting layer between the substrate and the light-absorbing layer, the light-reflecting layer reflects the laser passing through the substrate in the laser etching process, such that the laser is not irradiated to the portion of the light-absorbing layer not covered by the drive layer, the bubble of the light-absorbing layer is efficiently avoided, the flatness of the light-absorbing layer is great, and the reliability of the display panel is great.

Some embodiments of the present disclosure further provide a display panel. The display panel includes: a substrate, a drive layer, a light-absorbing layer, a plurality of signal lines, and a plurality of light-emitting units.

The drive layer is disposed on a side of the substrate, and a plurality of conductive pads are arranged on the drive layer. An edge region on a face, facing away from the drive layer, of the substrate includes a bonding region.

The light-absorbing layer is disposed on a side, facing away from the substrate, of the drive layer. An orthographic projection of the light-absorbing layer on the substrate is overlapped with an orthographic projection of the drive layer on the substrate. A plurality of first vias corresponding to the plurality of conductive pads are defined in the light-absorbing layer, and an orthographic projection of the first via on the substrate is overlapped with an orthographic projection of the corresponding conductive pad on the substrate.

The plurality of signal lines are all disposed in the bonding region, at least part of the plurality of signal lines are electrically connected to the drive layer, and a region between adjacent two drive signal lines is the spacer region.

The plurality of light-emitting units are disposed on a side, facing away from the substrate, of the light-absorbing layer, and are electrically connected to at least part of the plurality of conductive pads through the first via.

It should be noted that for the structure of the display panel, reference may be made to the structure of the display panel in the above embodiments, whereas the display panel is not provided with a light-reflecting layer, and other structures of the display panel are optimized to ensure that the laser irradiated to the spacer region is not irradiated to the light-absorbing layer.

Illustratively, in some embodiments, the structure of the light-absorbing layer in the display panel is optimized to dispose auxiliary grooves in the light-absorbing layer, and orthographic projections of the auxiliary grooves on the substrate are overlapped with a portion of an orthographic projection of the spacer region on the substrate not covered by the drive layer.

In some embodiments, the arrangement location or the shape of the spacer region between adjacent two signal lines in the bonding region is optimized to cause the drive layer to completely cover the spacer region.

In some embodiments, the structure of the drive layer in the display panel is optimized to cause the drive layer to completely cover the spacer region.

It should be noted that for principles of optimizing other structures of the display panel, reference may be made to corresponding description in the above embodiments, which are not described again herein.

Some embodiments of the present disclosure further provide a display device. The display device is a mobile phone, a tablet computer, a television, a monitor, a laptop computer, a digital photo frame, a navigator, or any product or component with the display function. The display device includes a drive assembly and the display panel in the above embodiments. The drive assembly is electrically connected with the drive layer in the display panel, and is configured to provide a drive signal to the light-emitting units through the drive layer.

It should be noted that in the accompanying drawings, for clarity of the illustration, the dimension of the layers and regions may be scaled up. It is understandable that when an element or layer is described as being "on" another element or layer, the described element or layer may be directly located on other elements or layers, or an intermediate layer may exist. In addition, it should be understood that when an element or layer is described as being "under" another element or layer, the described element or layer may be directly located under other elements, or more than one intermediate layer or element may exist. In addition, it should be further understood that when a layer or element is described as being arranged "between" two layers or elements, the described layer or element may be the only layer between the two layers or elements, or more than one intermediate layer or element may exist. In the whole disclosure, like reference numerals indicate like elements.

For example, the terms "first" and "second" are only intended to describe, and are not intended to indicate or imply relative importance. The term "a plurality of " herein means two or more, unless otherwise defined clearly.

Described above are merely optional embodiments of the present disclosure, and are not intended to limit the present disclosure. Any modifications, equivalent replacements, improvements and the like made within the spirit and principles of the present disclosure should be encompassed within the scope of protection of the present disclosure.

## Claims

1. A display panel, comprising:
a substrate;
a first metal drive layer on a side of the substrate, wherein a plurality of conductive pads are arranged on the first metal drive layer;
a light-absorbing layer on a side, facing away from the substrate, of the first metal drive layer, wherein an orthographic projection of the light-absorbing layer on the substrate is overlapped with an orthographic projection of the first metal drive layer on the substrate, and a plurality of first vias corresponding to the plurality of conductive pads are defined in the light-absorbing layer, wherein an orthographic projection of each of the plurality of first vias on the substrate is overlapped with an orthographic projection of a conductive pad corresponding to the each of the plurality of first vias on the substrate;
a plurality of light-emitting units on a side, facing away from the substrate, of the light-absorbing layer, wherein the plurality of light-emitting units are electrically connected to at least part of the plurality of conductive pads through the plurality of first vias; and
an auxiliary light-absorbing layer on a side, facing away from the substrate, of the plurality of light-emitting units.

2. The display panel according to claim 1, further comprising: a light-reflecting layer between the substrate and the light-absorbing layer, wherein an orthographic projection of the light-reflecting layer on the substrate is overlapped with the orthographic projection of the light-absorbing layer on the substrate.

3. The display panel according to claim 2, wherein the light-reflecting layer is disposed on the side, facing away from the substrate, of the first metal drive layer, and second vias in communication with the plurality of first vias are defined in the light-reflecting layer.

4. The display panel according to claim 3, wherein the orthographic projection of the light-absorbing layer on the substrate is within the orthographic projection of the light-reflecting layer on the substrate.

5. The display panel according to claim 4, further comprising: a first insulative layer between the first metal drive layer and the light-absorbing layer, wherein third vias in communication with the plurality of first vias are defined in the first insulative layer.

6. The display panel according to claim 5, wherein the light-reflecting layer is insulative, and the light-reflecting layer and the first insulative layer are in a same film layer structure.

7. The display panel according to claim 5, wherein the light-reflecting layer is disposed on a side, facing away from the substrate, of the first insulative layer, or the light-reflecting layer is disposed on a side, close to the substrate, of the first insulative layer.

8. The display panel according to claim 3, further comprising: a second insulative layer on the side, facing away from the substrate, of the light-absorbing layer, wherein fourth vias in communication with the plurality of first vias are defined in the second insulative layer, and a portion of the second insulative layer extends into the plurality of first vias and covers at least part of inner walls of the plurality of first vias.

9. The display panel according to claim 8, wherein the light-absorbing layer comprises carbon particles, and the inner walls of the plurality of first vias are completely covered by the second insulative layer.

10. The display panel according to claim 9, wherein the portion of the second insulative layer further extends into the second vias and covers at least part of inner walls of the second vias.

11. The display panel according to claim 2, further comprising: a second metal drive layer on a side, close to the substrate, of the first metal drive layer, wherein the light-reflecting layer is disposed on a side, close to the substrate, of the second metal drive layer.

12. The display panel according to claim 11, wherein mark patterns are arranged on at least one of the first metal drive layer or the second metal drive layer, and avoidance holes corresponding to the mark patterns are defined in the light-absorbing layer, wherein orthographic projections of the avoidance holes on the substrate are overlapped with orthographic projections of the mark patterns on the substrate.

13. The display panel according to any one of claims 2 to 12, wherein a material of the light-reflecting layer comprises at least one of amorphous silicon, low-temperature polycrystalline silicon, or white ink.

14. The display panel according to claim 13, wherein
in a case that the material of the light-reflecting layer comprises the amorphous silicon, a thickness of the light-reflecting layer ranges from 500 angstroms to 2000 angstroms;
in a case that the material of the light-reflecting layer comprises the white ink, a thickness of the light-reflecting layer ranges from 0.5 microns to 3 microns; or
in a case that the material of the light-reflecting layer comprises the low-temperature polycrystalline silicon, a thickness of the light-reflecting layer ranges from 500 angstroms to 2000 angstroms.

15. The display panel according to claim 1, wherein
the display panel further comprises: a plurality of drive circuits on a side, close to the substrate, of the first metal drive layer, wherein the plurality of drive circuits are electrically connected to the plurality of light-emitting units through the plurality of conductive pads, and each of the plurality of drive circuits comprises a plurality of laminated electrical patterns; and
the display panel further comprises: an insulative layer between adjacent two of the plurality of electrical patterns.

16. The display panel according to claim 15, further comprising: a light-reflecting layer in a same layer as one of the plurality of electrical patterns, wherein an orthographic projection of the light-reflecting layer on the substrate is overlapped with the orthographic projection of the light-absorbing layer on the substrate.

17. The display panel according to claim 16, wherein each of the plurality of drive circuits comprises at least one transistor, wherein
one of the plurality of electrical patterns is an active layer pattern in the at least one transistor, wherein a material of the active layer pattern and a material of the light-reflecting layer both comprise low-temperature polycrystalline silicon; and
the active layer and the light-reflecting layer are disposed in a same layer with a same material.

18. The display panel according to claim 17, wherein a width of a minimum spacing between an outer boundary of an orthographic projection of the active layer pattern on the substrate and an outer boundary of the orthographic projection of the light-reflecting layer on the substrate is greater than or equal to 5 microns.

19. The display panel according to claim 17, wherein an edge region of a face, facing away from the first metal drive layer, of the substrate comprises a bonding region, and the display panel further comprises a plurality of signal lines in the bonding region, wherein at least part of the plurality of signal lines are electrically connected to the plurality of drive circuits, and a region between adjacent two of the plurality of drive signal lines is a spacer region, wherein an orthographic projection of the spacer region on the substrate is overlapped with the orthographic projection of the light-reflecting layer on the substrate.

20. The display panel according to claim 19, wherein the spacer region comprises a first region and a second region; wherein the first region is a region in the spacer region covered by the first metal drive layer and the plurality of electrical patterns, the second region is a region in the spacer region other than the first region, and at least part of the orthographic projection of the light-reflecting layer on the substrate is within an orthographic projection of the second region on the substrate.

21. The display panel according to claim 20, wherein the orthographic projection of the light-reflecting layer on the substrate is not coincident with the orthographic projection of the first metal drive layer on the substrate, and is not coincident with orthographic projections of the plurality of electrical patterns on the substrate.

22. The display panel according to claim 20, wherein the orthographic projection of the light-reflecting layer on the substrate completely covers the second region.

23. The display panel according to claim 20, wherein a boundary of an orthographic projection of a portion of the light-reflecting layer covered by the second region on the substrate extends along a boundary of an orthographic projection of the first region on the substrate, and is not coincident with the boundary of the orthographic projection of the first region on the substrate.

24. The display panel according to any one of claims 16 to 23, further comprising: mark patterns in a same layer as at least one of the plurality of electrical patterns with a same material, and avoidance holes corresponding to the mark patterns are defined in the light-reflecting layer, wherein orthographic projections of the avoidance holes on the substrate are overlapped with orthographic projections of the mark patterns on the substrate.

25. The display panel according to claim 24, wherein the plurality of electrical patterns comprise a first gate pattern, an active layer pattern, a second gate pattern, and a source-drain pattern that are laminated in a direction perpendicular to and away from the substrate, wherein in a case that the light-reflecting layer and the active layer pattern are disposed in a same layer, at least two mark patterns are defined, one of the at least two mark patterns being disposed in a same layer as the second gate pattern with a same material, and another of the at least two mark patterns being disposed in a same layer as the source-drain pattern with a same material.

26. The display panel according to any one of claims 1 to 12, 14 to 23 and 25, wherein a transmittance of the auxiliary light-absorbing layer to light emitted by the plurality of light-emitting units is greater than or equal to 50%.

27. The display panel according to any one of claims 1 to 12, 14 to 23 and 25, wherein the plurality of light-emitting units comprise mini light-emitting diodes or micro light-emitting diodes.

28. A display device, comprising: a drive assembly and a display panel electrically connected to the drive assembly, wherein the display panel is the display panel as defined in any one of claims 1 to 27.
